(19) **Europäisches Patentamt / European Patent Office / Office européen des brevets**

(11) **EP 1 927 266 B1**

(12) **EUROPEAN PATENT SPECIFICATION**

(45) Date of publication and mention
of the grant of the patent:
**14.05.2014 Bulletin 2014/20**

(51) Int Cl.:
*H04S 3/00* (2006.01)

(21) Application number: **06795846.2**

(86) International application number:
**PCT/IB2006/053040**

(22) Date of filing: **31.08.2006**

(87) International publication number:
**WO 2007/031896 (22.03.2007 Gazette 2007/12)**

(54) **AUDIO CODING**

AUDIOKODIERUNG

CODAGE AUDIO

(84) Designated Contracting States:
**AT BE BG CH CY CZ DE DK EE ES FI FR GB GR HU IE IS IT LI LT LU LV MC NL PL PT RO SE SI SK TR**

(30) Priority: **13.09.2005 EP 05108405**
**21.02.2006 EP 06110231**

(43) Date of publication of application:
**04.06.2008 Bulletin 2008/23**

(73) Proprietor: **Koninklijke Philips N.V.**
**5656 AE Eindhoven (NL)**

(72) Inventor: **BREEBAART, Dirk, J.**
**NL-5656 AA Eindhoven (NL)**

(74) Representative: **Verweij, Petronella Danielle et al**
**Philips Intellectual Property & Standards**
**P.O. Box 220**
**5600 AE Eindhoven (NL)**

(56) References cited:
EP-A2- 1 194 007      WO-A2-2004/028204
US-A- 6 111 958      US-A1- 2003 035 553

- HERRE J ET AL: "THE REFERENCE MODEL ARCHITECTURE FOR MPEG SPATIAL AUDIO CODING" AUDIO ENGINEERING SOCIETY CONVENTION PAPER, NEW YORK, NY, US, 28 May 2005 (2005-05-28), pages 1-13, XP009059973
- ENGDEGAARD J ET AL: "SYNTHETIC AMBIENCE IN PARAMETRIC STEREO CODING" PREPRINTS OF PAPERS PRESENTED AT THE AES CONVENTION, XX, XX, 8 May 2004 (2004-05-08), pages 1-12, XP008048096
- HERRE J ET AL: "MP3 Surround: Efficient and Compatible Coding of Multi-Channel Audio" AUDIO ENGINEERING SOCIETY. CONVENTION PREPRINT, 8 May 2004 (2004-05-08), pages 1-14, XP002338414
- BAUMGARTE F ET AL: "Binaural cue coding-Part I: psychoacoustic fundamentals and design principles" IEEE TRANSACTIONS ON SPEECH AND AUDIO PROCESSING, IEEE SERVICE CENTER, NEW YORK, NY, US, vol. 11, no. 6, November 2003 (2003-11), pages 509-519, XP002388802 ISSN: 1063-6676
- FALLER C ET AL: "Binaural Cue Coding -Part II: Schemes and Applications" IEEE TRANSACTIONS ON SPEECH AND AUDIO PROCESSING, IEEE SERVICE CENTER, NEW YORK, NY, US, vol. 11, no. 6, 6 October 2003 (2003-10-06), pages 520-531, XP002338415 ISSN: 1063-6676

**Description**

The present invention relates to audio coding. More in particular, the present invention relates to a device for and a method of converting an audio input signal into a binaural output signal, wherein the input signal comprises at least one audio channel and parameters representing additional channels.

It is well known to record and reproduce binaural audio signals, that is, audio signals which contain specific directional information to which the human ear is sensitive. Binaural recordings are typically made using two microphones mounted in a dummy human head, so that the recorded sound corresponds to the sound captured by the human ear and includes any influences due to the shape of the head and the ears. Binaural recordings differ from stereo (that is, stereophonic) recordings in that the reproduction of a binaural recording requires a headset, whereas a stereo recording is made for reproduction by loudspeakers. While a binaural recording allows a reproduction of all spatial information using only two channels, a stereo recording would not provide the same spatial perception.

Regular dual channel (stereophonic) or multiple channel (e.g. 5.1) recordings may be transformed into binaural recordings by convolving each regular signal with a set of perceptual transfer functions. Such perceptual transfer functions model the influence of the human head, and possibly other objects, on the signal. A well-known type of perceptual transfer function is the so-called Head-Related Transfer Function (HRTF). An alternative type of perceptual transfer function, which also takes into account reflections caused by the walls, ceiling and floor of a room, is the Binaural Room Impulse Response (BRIR).

In the case of multiple channel signals, transforming the signals into binaural recording signals with a set of perceptual functions typically implies a convolution of perceptual functions with the signals of all channels. As a typical convolution is computationally demanding, the signals and the HRTF are typically transformed to the frequency (Fourier) domain where the convolution is replaced with a computationally far less demanding multiplication.

It is further well known to reduce the number of audio channels to be transmitted or stored by representing the original number of channels by a smaller number of channels and parameters indicative of the relationships between the original channels. A set of stereo signals may thus be represented by a single (mono) channel plus a number of associated spatial parameters, while a set of 5.1 signals may be represented by two channels and a set of associated spatial parameters, or even by a single channel plus the associated spatial parameters. This "downmixing" of multiple audio channels in spatial encoders, and the corresponding "upmixing" of audio signals in spatial decoders, is typically carried out in a transform domain or sub-band domain, for example the QMF (Quadrature Mirror Filter) domain.

Patent Cooperation Treaty Patent Application WO2004/028204 discloses a system for generating binaural signals using Head Related Transfer Functions; the document "The Reference Model Architecture for MPEG Spatial Audio Coding"; Herre et al; Audio Engineering Society Convention Paper, New York; 28 May 2005; XP009059973 discloses the MPEG reference Model architecture; the document "Synthetic Ambiance in Parametric Stereo Coding", Endegard et al; Preprints of papers presented at the AES Convention, 8 May 2004, pages 1-12, XP008048096 discloses an example of parametric stereo coding; and the document "MP3 Surround: Efficient and Compatible Coding of Multi-Channel Audio"; Herre et al. Audio Engineering Society, Convention Preprint, 8 May 2004; XP002338414 discloses examples of MP3 Surround encoding. US 2003/035553 discloses perceptual coding of spatial cues which are used to convert input audio signals into a combined audio signal embedded with auditory scene parameters. Baumgarte "Binaural cue coding - Part 1: Psychoacoustic fundamentals and design principles", IEEE transactions on Speech and Audio Processing", NY, US, vol. 11, no 6 2003-11, XP002388802 ISSN: 1063-6676 and "Binaural cue coding - Part II: Schemes and Applications", IEEE transactions on Speech and Audio Processing", NY, US, vol. 11, no 6 2003-11, XP002338415 ISSN: 1063-6676 discloses various aspects of binaural coding. EP-A-1 194 007 discloses a method for converting signals in two-channel stereo format to become suitable to be played back using headphones, and US-A-6 111 958 discloses a spatial enhancement system broadens the sound image of a stereo signal.

When downmixed input channels are to be converted into binaural output channels, the Prior Art approach is to first upmix the input channels using a spatial decoder to produce upmixed intermediary channels, and then convert these upmixed intermediary channels into binaural channels. This procedure typically produces five or six intermediary channels, which then have to be reduced to two binaural channels. First expanding and then reducing the number of channels is clearly not efficient and increases the computational complexity. In addition, reducing the five or six intermediary channels meant for multiple channel loudspeaker reproduction to only two channels meant for binaural reproduction inevitably introduces artifacts and therefore decreases the sound quality.

The QMF domain referred to above is similar, but not identical, to the frequency (Fourier transform) domain. If a spatial decoder is to produce binaural output signals, the downmixed audio signals would first have to be transformed to the QMF domain for upmixing, then be inversely QMF transformed to produce time domain intermediary signals, subsequently be transformed to the frequency domain for multiplication with the (Fourier transformed) HRTF, and finally be inversely transformed to produce time domain output signals. It will be clear that this procedure is not efficient, as several transforms must be performed in succession.

The number of computations involved in this Prior Art approach would make it very difficult to design a hand-held consumer device, such as a portable MP3 player, capable of producing binaural output signals from downmixed audio signals. Even if such a device could be implemented, its battery life would be very short due to the required computational load.

It is an object of the present invention to overcome these and other problems of the Prior Art and to provide a spatial decoder unit capable of producing a pair of binaural output channels from a set of downmixed audio channels represented by one audio input channels and an associated set of spatial parameters, which decoder has an increased efficiency.

Accordingly, the present invention provides a spatial decoder unit for producing a pair of binaural output channels in accordance with claim 1 or 2.

By converting the spatial parameters into binaural parameters, the spatial synthesis unit can directly synthesize a pair of binaural channels, without requiring an additional binaural synthesis unit. As no superfluous intermediary signals are produced, the computational requirements are reduced while the introduction of artifacts is substantially eliminated.

In the spatial decoder unit of the present invention, the synthesis of the binaural channels can be carried out in the transform domain, for example the QMF domain, without requiring the additional steps of transformation to the frequency domain and the subsequent inverse transformation to the time domain. As two transform steps can be omitted, both the number of computations and the memory requirements are significantly reduced. The spatial decoder unit of the present invention can therefore relatively easily be implemented in a portable consumer device.

Furthermore, in the spatial decoder unit of the present invention, binaural channels are produced directly from a downmixed channel, each binaural channel comprising binaural signals for binaural reproduction using a headset or a similar device. The parameter conversion unit derives the binaural parameters used for producing the binaural channels from spatial (that is, upmix) parameters. This derivation of the binaural parameters involves parameterized perceptual transfer functions, such as HRTFs (Head-Related Transfer Functions) and/or Binaural Room Impulse Responses (BRIRs). According to the present invention, therefore, the processing of the perceptual transfer functions is performed in the parameter domain, while in the Prior Art this processing was carried out in the time domain or the frequency domain. This may result in a further reduction of the computational complexity as the resolution in the parameter domain is typically lower than the resolution in the time domain or the frequency domain.

It is preferred that the parameter conversion unit is arranged for combining in the parameter domain, in order to determine the binaural parameters, all perceptual transfer function contributions the input (downmix) audio channels would make to the binaural channels. In other words, the spatial parameters and the parameterized perceptual transfer functions are combined in such a manner that the combined parameters result in a binaural output signal having similar statistical properties to those obtained in the Prior Art method involving upmixed intermediary signals.

In a preferred embodiment, the spatial decoder unit of the present invention further comprises one or more transform units for transforming the audio input channels into transformed audio input channels, and a pair of inverse transform units for inversely transforming the synthesized binaural channels into the pair of binaural output channels, wherein the spatial synthesis unit is arranged for operating in a transform domain or sub-band domain, preferably the QMF domain.

The spatial decoder unit of the present invention may comprise two transform units, the parameter conversion unit being arranged for utilizing perceptual transfer function parameters involving three channels only, two of these three channels incorporating the contributions of composite front and rear channels. In such an embodiment, the parameter conversion unit may be arranged for processing channel level (e.g. CLD), channel coherence (e.g. ICC), channel prediction (e.g. CPC) and/or phase (e.g. IPD) parameters.

The spatial decoder unit of may comprise only a single transform unit, and further comprises a decorrelation unit for decorrelating the transformed single channel output by the single transform unit. In such an embodiment, the parameter conversion unit may be arranged for processing channel level (e.g. CLD), channel coherence (e.g. ICC), and/or phase (e.g. IPD) parameters.

The spatial decoder unit of the present invention may additionally comprise a stereo reverberation unit. Such a stereo reverberation unit may be arranged for operating in the time domain or in a transform domain or sub-band (e.g. QMF) domain.

The present invention also provides a spatial decoder device for producing a pair of binaural output channels from an input bitstream, the device comprising a demultiplexer unit for demultiplexing the input bitstream into a single downmix channel and spatial parameters, a downmix decoder unit for decoding the single downmix channel, and a spatial decoder unit for producing a pair of binaural output channels using the spatial parameters and the single downmix channel.

In addition, the present invention provides a consumer device and an audio system comprising a spatial decoder unit and/or spatial decoder device as defined above. The present invention further provides a method of producing a pair of binaural output channels in accordance with claim 7 or 8.

Further aspects of the method according to the present invention will become apparent from the description below.

The present invention additionally provides a computer program product for carrying out the method as defined above. A computer program product may comprise a set of computer executable instructions stored on a data carrier, such as a CD or a DVD. The set of computer executable instructions, which allow a programmable computer to carry out the method as defined above, may also be available for downloading from a remote server, for example via the Internet.

The present invention will further be explained below with reference to exemplary embodiments illustrated in the accompanying drawings, in which:

Fig. 1 schematically shows the application of head-related transfer functions according to the Prior Art.
Fig. 2 schematically shows a spatial audio encoder device according to the Prior Art.
Fig. 3 schematically shows a spatial audio decoder device according to the Prior Art coupled to a binaural synthesis device.
Fig. 4 schematically shows a spatial audio decoder unit according to the Prior Art.
Fig. 5 schematically shows an example of a spatial audio decoder unit.
Fig. 6 schematically shows a spatial audio decoder device according to the present invention.
Fig. 7 schematically shows the spatial audio decoder unit of Fig. 6, provided with a transform domain reverberation unit.
Fig. 8 schematically shows the spatial audio decoder unit of Fig. 6, provided with a time domain reverberation unit.
Fig. 9 schematically shows a consumer device provided with a spatial audio decoder device according to the present invention.

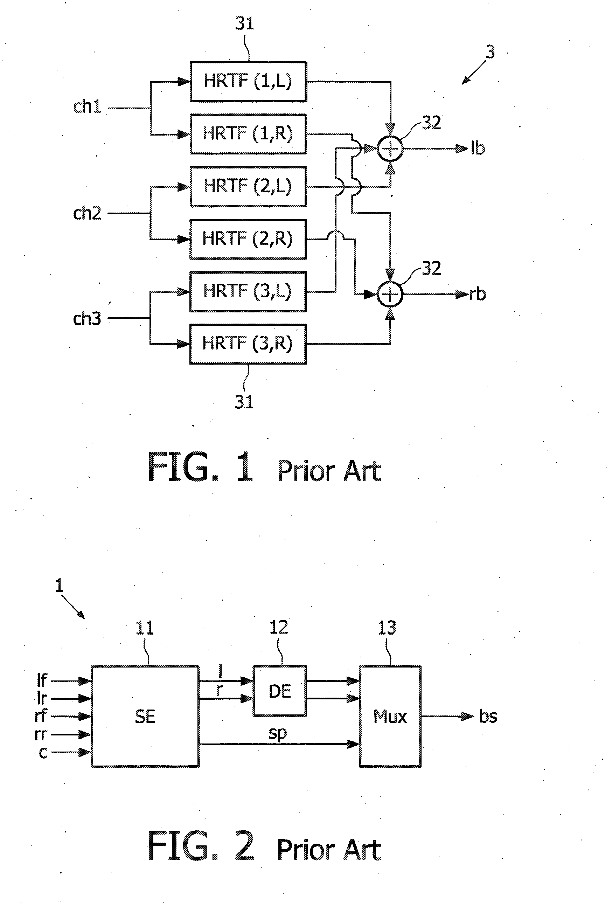

The application of perceptual transfer functions, such as Head-Related Transfer Functions (HRTFs), in accordance with the Prior Art is schematically illustrated in Fig. 1. The binaural synthesis device 3 is shown to comprise six HRTF units 31, each containing the transfer function for a specific combination of an input channel and an output channel. In the example shown, there are three audio input channels ch1, ch2 and ch3, which may correspond to the channels 1 (left), c (center) and r (right). The first channel ch1 is fed to two HRTF units 31 containing HRTF(1,L) and HRTF(1,R) respectively. In this example, HRTF(1,L) is the head-related transfer function which determines the contribution of the first channel to the left binaural signal.

Those skilled in the art will know that HRTFs may be determined by making both regular (stereo) recordings and binaural recordings, and deriving a transfer function which represents the shaping of the binaural recording relative to the regular recording. Binaural recordings are made using two microphones mounted in a dummy human head, so that the recorded sound corresponds to the sound captured by the human ear and includes any influences due to the shape of the head and the ears, and even the presence of hair and shoulders.

If the HRTF processing takes place in the time domain, the HRTFs are convolved with the (time domain) audio signals of the channels. Typically, however, the HRTFs are transformed to the frequency domain, and the resulting transfer functions and the frequency spectra of the audio signals are then multiplied (Fourier transform units and inverse Fourier transform units are not shown in Fig. 1). Suitable Overlap-and-Add (OLA) techniques involving overlapping time frames may be used to accommodate HRTFs having a greater length than the Fast Fourier Transform (FFT) frames.

After HRTF processing by the appropriate HRTF unit 31, the resulting left and right signals are added by a respective adder 32 to yield the (time domain) left binaural signal lb and the right binaural signal rb.

The exemplary Prior Art binaural synthesis device 3 of Fig. 1 has three input channels. Present-day audio systems often have five or six channels, as is the case in so-called 5.1 systems. However, in order to reduce the amount of data to be transferred and/or stored, the multiple audio channels are typically reduced ("downmixed") to one or two channels. A number of spatial parameters indicative of the properties and mutual relationships of the original channels allows an expansion ("upmixing") of the one or two channels to the original number of channels. An exemplary spatial encoder device 1 according to the Prior Art is schematically illustrated in Fig. 2.

The spatial encoder device 1 comprises a spatial encoding (SE) unit 11, a downmix encoding (DE) unit 12 and a multiplexer (Mux) 13. The spatial encoding unit 11 receives five audio input channels lf (left front), lr (left rear), rf (right front), rr (right rear) and c (center). The spatial encoding unit 11 downmixes the five input channels to produce two channels 1 (left) and r (right), as well as spatial parameters sp (it is noted that the spatial encoding unit 11 may produce a single channel instead of the two channels 1 and r). In the embodiment shown, where five channels are downmixed to two channels (a so-called 5-2-5 configuration), the spatial parameters sp may for example comprise:

| Parameter | Description |
| --- | --- |
| $CPC_1$ | Prediction/energy parameter for 2-to-3 conversion |
| $CPC_2$ | Prediction/energy parameter for 2-to-3 conversion |
| $CLD_1$ | Level difference left front vs. left rear |

(continued)

| Parameter | Description |
|---|---|
| $CLD_r$ | Level difference right front vs. right rear |
| $ICC_1$ | Correlation left front vs. left rear |
| $ICC_r$ | Correlation right front vs. right rear |
| $ICC_f$ | Correlation parameter for 2-to-3 conversion |
| $CLD_{lfe}$ | Level difference center vs. lfe (if applicable) |

It is noted that "lfe" is an optional low frequency (sub-woofer) channel, and that the "rear" channels are also known as "surround" channels.

The two downmix channels l and r produced by the spatial encoding unit 11 are fed to the downmix encoding (DE) unit 12, which typically uses a type of coding aimed at reducing the amount of data. The thus encoded downmix channels l and r, and the spatial parameters sp, are multiplexed by the multiplexer unit 13 to produce an output bit stream bs.

In an alternative embodiment (not shown), five (or six) channels are downmixed to a single (mono) channel (a so-called 5-1-5 configuration), and the spatial parameters sp may for example comprise:

| Parameter | Description |
|---|---|
| $CLD_{fs}$ | Level difference front vs. rear |
| $CLD_{fc}$ | Level difference front vs. center |
| $CLD_f$ | Level difference front left vs. front right |
| $CLD_s$ | Level difference left rear vs. right rear |
| $ICC_{fs}$ | Correlation front vs. rear |
| $ICC_{fc}$ | Correlation front vs. center |
| $ICC_f$ | Correlation front left vs. front right |
| $ICC_s$ | Correlation left rear vs. right rear |
| $CLD_{lfe}$ | Level difference center vs. lfe (if applicable) |

In this alternative embodiment the encoded downmix channel s, as well as the spatial parameters sp, are also multiplexed by the multiplexer unit 13 to produce an output bit stream bs.

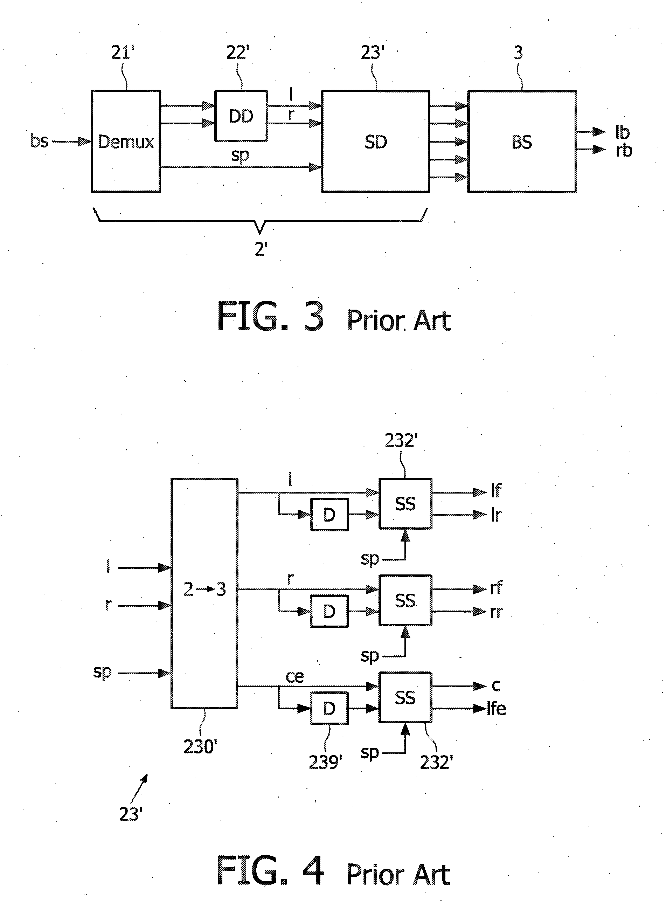

If this bitstream bs were to be used to produce a pair of binaural channels, the Prior Art approach would be to first upmix the two downmix channels l and r (or, alternatively, the single downmix channel) to produce the five or six original channels, and then convert these five or six channels into two binaural channels. An example of this Prior Art approach is illustrated in Fig. 3.

The spatial decoder device 2' according to the Prior Art comprises a demultiplexer (Demux) unit 21', a downmix decoding unit 22', and a spatial decoder unit 23'. A binaural synthesis device 3 is coupled to the spatial decoder unit 23' of the spatial decoder device 2'.

The demultiplexer unit 21' receives a bitstream bs, which may be identical to the bitstream bs of Fig. 2, and outputs spatial parameters sp and two encoded downmix channels. The spatial parameters sp are sent to the spatial decoder unit 23', while the encoded downmix channels are first decoded by the downmix decoding unit 22' to produce the decoded downmix channels l and r. The spatial decoder unit 23' essentially carries out the inverse operations of the spatial encoding unit 11 in Fig. 2 and outputs five audio channels. These five audio channels are fed to the binaural synthesis device 3, which may have a structure similar to the device 3 of Fig. 1 but with additional HRTF units 31 to accommodate all five channels. As in the example of Fig. 1, the binaural synthesis device 3 outputs two binaural channels lb (left binaural) and rb (right binaural).

An exemplary structure of the spatial decoder unit 23' of the Prior Art is shown in Fig. 4. The unit 23' of Fig. 4 comprises a two-to-three upmix unit 230', three spatial synthesis (SS) units 232' and three decorrelation (D) units 239'. The two-to-three upmix unit 230' receives the downmix channels l & r and the spatial parameters sp, and produces three channels l, r and ce. Each of these channels is fed to a decorrelator unit 239' which produces a decorrelated version of the respective channel. Each channel l, r and ce, its respective decorrelated version, and associated spatial parameters sp are fed to a respective spatial synthesis (or upmix) unit 232'. The spatial synthesis unit 232' receiving the channel 1, for example, outputs the output channels lf (left front) and lr (left rear). The spatial synthesis units 232' typically perform a matrix multiplication, the parameters of the matrix being determined by the spatial parameters sp.

It is noted that in the example of Fig. 4 six output channels are produced. In some embodiments, the third decorrelation unit 239' and the third spatial synthesis unit 232' may be omitted, thus producing only five output channels. In all embodiments, however, the spatial synthesis unit 23' of the Prior Art will produce more than two output channels. It is further noted that any (QMF) transform units and inverse (QMF) transform units have been omitted from the merely illustrative example of Fig. 4 for the sake of clarity of the illustration. In actual embodiments the spatial decoding would be carried out in a transform domain, such as the QMF domain.

The configuration of Fig. 3 is not efficient. The spatial decoder device 2' converts two downmix channels (l and r) into five upmixed (intermediary) channels, while the binaural synthesis device 3 then reduces the five upmixed channels to two binaural channels. In addition, the upmixing in the spatial decoder unit 23' is typically carried out in a sub-band domain, such as the QMF (Quadrature Mirror Filter) domain. However, the binaural synthesis device 3 typically processes signals in the frequency (that is, Fourier transform) domain. As these two domains are not identical, the spatial decoder device 2' first transforms the signals of the downmix channels into the QMF domain, processes the transformed signals, and then transforms the upmixed signals back to the time domain. Subsequently, the binaural synthesis device 3 transforms all (five in the present example) these upmixed signals into the frequency domain, processes the transformed signals, and then transforms the binaural signals back into the time domain. It will be clear that the computational effort involved is considerable, and that a more efficient signal processing is desired, in particular when this processing is to be carried out in a hand-held device.

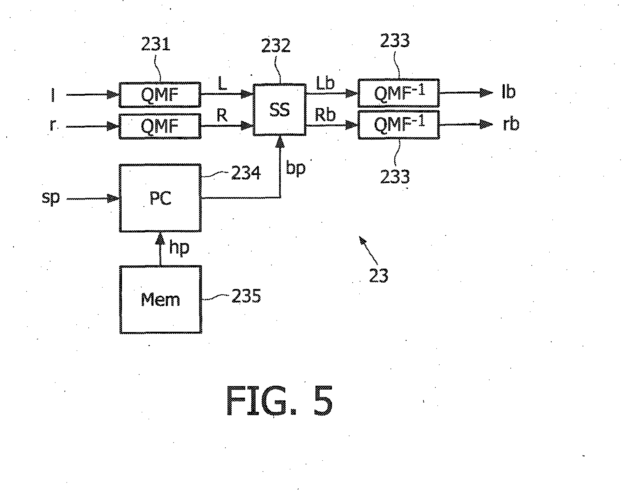

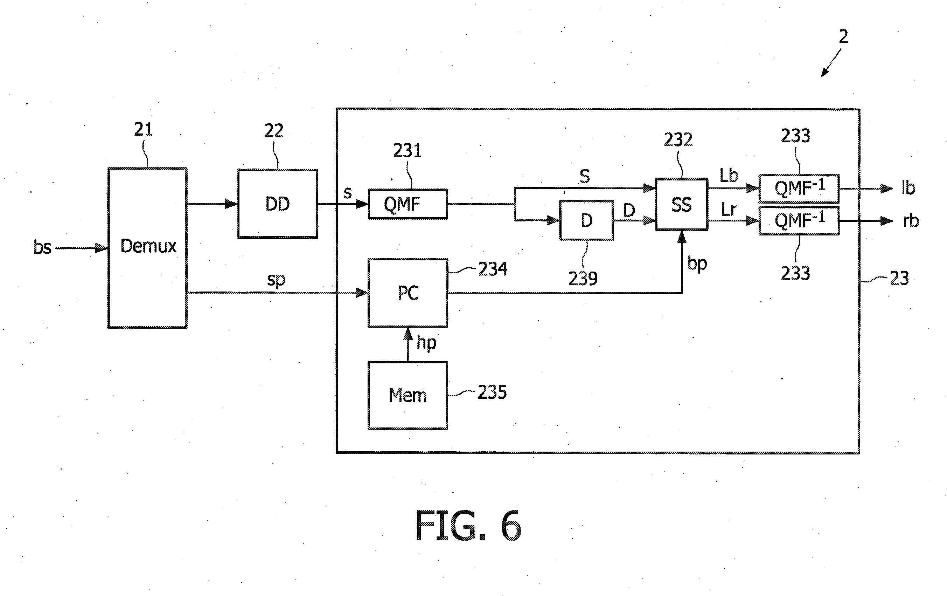

The present invention provides a far more efficient processing by integrating the binaural synthesis device in the spatial decoder device and effectively carrying out the binaural processing in the parameter. An example of a spatial decoder unit is schematically illustrated in Fig. 5, while a combined spatial and binaural decoder device according to the present invention (referred to as spatial decoder device for the sake of brevity) is illustrated in Fig. 6.

The spatial decoder unit 23 shown in Fig. 5 comprises transform units 231, a spatial synthesis (SS) unit 232, inverse transform units 233, a parameter conversion (PC) unit 234 and a memory (Mem) unit 235. In the exemple of Fig. 5, the spatial decoder unit 23 comprises two transform units 231, but in other examples only a single transform unit 231 (as in Fig. 6), or more than two transform units 231 may be present, depending on the number of downmix channels.

The transform units 231 each receive a downmix channel l and r respectively (see also Fig. 3). Each transform unit 231 is arranged for transforming the (signal of the) respective channel into a suitable transform or sub-band domain, in the present example the QMF domain. The QMF transformed channels L and R are fed to the spatial synthesis unit 232 which preferably carries out a matrix operation on the signals of the channels L and R to produce the transform domain binaural channels Lb and Rb. Inverse transform units 233 carry out an inverse transform, in the present example an inverse QMF transform, to produce the binaural time domain channels lb and rb.

The spatial synthesis unit 232 may be similar or identical to the Prior Art spatial synthesis unit 232' of Fig. 4. However, the parameters used by this unit are different from those used in the Prior Art. More in particular, the parameter conversion unit 234 converts the conventional spatial parameters sp into binaural parameters bp using HRTF parameters stored in the memory unit 235. These HRTF parameters may comprise:

- an average level per frequency band for the left transfer function as a function of azimuth (angle in a horizontal plane), elevation (angle in a vertical plane), and distance,
- an average level per frequency band for the right transfer function as a function of azimuth, elevation and distance, and
- an average phase or time difference per frequency band as a as a function of azimuth, elevation and distance.

In addition, the following parameters may be included:

- a coherence measure of the left and right transfer functions per HRTF frequency band as a function of azimuth, elevation and distance, and/or
- absolute phase and/or time parameters for the left and right transfer functions as a function of azimuth, elevation and distance.

The actual HRTF parameters used may depend on the particular embodiment.

The spatial synthesis unit 232 may determine the binaural channels Lb and Rb using the following formula:

$$\begin{bmatrix} Lb[k,m] \\ Rb[k,m] \end{bmatrix} = H_k \begin{bmatrix} L[k,m] \\ R[k,m] \end{bmatrix} = \begin{bmatrix} h_{11} & h_{12} \\ h_{21} & h_{22} \end{bmatrix}_k \begin{bmatrix} L[k,m] \\ R[k,m] \end{bmatrix} \qquad (1)$$

where the index $k$ denotes the QMF hybrid (frequency) band index and the index m denotes the QMF slot (time) index. The parameters $h_{ij}$ of the matrix $H_k$ are determined by the binaural parameters (bp in Fig. 5). As indicated by the index $k$, the matrix $H_k$ may depend on the QMF hybrid band. In one example, the parameter conversion unit (234 in Fig. 5) produces the binaural parameters which are then converted into the matrix parameters $h_{ij}$ by the spatial synthesis unit 232. In another example, the matrix parameters $h_{ij}$ are identical to the binaural parameters produced by the parameter conversion unit (234 in Fig. 5) and can be directly applied by the spatial synthesis unit 232 without being converted.

The parameters $h_{ij}$ of the matrix $H_k$ may be determined in the following way in the case of two downmix channels (5-2-5 configuration). In the Prior Art spatial decoder unit of Fig. 4, a 2-to-3 decoder unit 230' converts the two (input) downmix channels l and r into three (output) channels l, r, and ce (it will be understood that the output channels l and r will typically not be identical to the input channels l and r, for this reason the input channels will in the following discussion be labeled $l_0$ and $r_0$).

In accordance with a example the parameter conversion unit (234 in Figs. 5 & 6) is arranged for utilizing perceptual transfer function parameters where the contribution of only three channels only (e.g. l, r and c) is taken into account, two of these three channels (e.g. l and r) comprising composite respective front (lf, rf) and rear (lr, rr) channels. That is, the respective front and rear channels are grouped together to improve the efficiency.

The operation of the two-to-three upmix unit 230' can be described by the following matrix operation:

$$\begin{bmatrix} l \\ r \\ c \end{bmatrix} = \begin{bmatrix} m_{11} & m_{12} \\ m_{21} & m_{22} \\ m_{31} & m_{32} \end{bmatrix} \begin{bmatrix} l_0 \\ r_0 \end{bmatrix} \quad (2)$$

with matrix entries $m_{ij}$ dependent on the spatial parameters. The relation of spatial parameters and matrix entries is identical to those of a 5.1 MPEG surround decoder. For each of the three resulting signals $l$, $r$ and $c$, the effect is determined of the perceptual transfer function (in the present example: HRTF) parameters which correspond to the desired (perceived) position of these sound sources. For the center channel (c), the spatial parameters of the sound source position can be applied directly, resulting in two output signals for center, $l_B(c)$ and $r_B(c)$:

$$\begin{bmatrix} l_B(c) \\ r_B(c) \end{bmatrix} = \begin{bmatrix} H_l(c) \\ H_r(c) \end{bmatrix} c = \begin{bmatrix} P_l(c)e^{+j\phi(c)/2} \\ P_r(c)e^{-j\phi(c)/2} \end{bmatrix} c \quad (3)$$

As can be observed from equation (3), the HRTF parameter processing consists of a multiplication of the signal with average power levels $P_l$ and $P_r$ corresponding to the sound source position of the center channel, while the phase difference is distributed symmetrically. This process is performed independently for each QMF band, using the mapping from HRTF parameters to QMF filter bank on the one hand, and mapping from spatial parameters to QMF band on the other hand.

For the left ($l$) channel, the HRTF parameters from the left-front and left-rear channels are combined into a single contribution, using the weights $w_{lf}$ and $w_{rf}$. The resulting composite parameters simulate the effect of both the front and rear channels in a statistical sense. The following equations are used to generate the binaural output pair ($l_b$, $r_b$) for the left channel:

$$\begin{bmatrix} l_b(l) \\ r_b(l) \end{bmatrix} = \begin{bmatrix} H_l(l) \\ H_r(l) \end{bmatrix} l \quad (4)$$

with

$$H_l(l) = \sqrt{w_{lf}^2 P_l^2(lf) + w_{lr}^2 P_l^2(lr)} \quad (5)$$

and

$$H_r(l) = e^{-j(w_{lf}^2 \phi(lf) + w_{ls}^2 \phi(lr))} \sqrt{w_{lf}^2 P_r^2(lf) + w_{lr}^2 P_r^2(lr)} \tag{6}$$

The weights $w_{lf}$ and $w_{rf}$ depend on the CLD parameter of the 1-to-2 unit for lf and lr:

$$w_{lf}^2 = \frac{10^{CLD_l/10}}{1 + 10^{CLD_l/10}} \tag{7},$$

$$w_{lr}^2 = \frac{1}{1 + 10^{CLD_l/10}} \tag{8}$$

In a similar fashion, the binaural output for the right channel is obtained according to:

$$\begin{bmatrix} L_b(r) \\ R_b(r) \end{bmatrix} = \begin{bmatrix} H_l(r) \\ H_r(r) \end{bmatrix} r \tag{9},$$

with

$$H_l(r) = e^{+j(w_{rf}^2 \phi(rf) + w_{rs}^2 \phi(rr))} \sqrt{w_{rf}^2 P_l^2(rf) + w_{rr}^2 P_l^2(rs)} \tag{10}$$

$$H_r(r) = \sqrt{w_{rf}^2 P_r^2(rf) + w_{rr}^2 P_r^2(rr)} \tag{11}$$

$$w_{rf}^2 = \frac{10^{CLD_r/10}}{1 + 10^{CLD_r/10}} \tag{12}$$

$$w_{rr}^2 = \frac{1}{1 + 10^{CLD_r/10}} \tag{13}.$$

It is noted that the phase modification term is applied to the contra-lateral ear in both cases. Furthermore, since the human auditory system is largely insensitive to binaural phase for frequencies above approx. 2 kHz, the phase modification term only needs to be applied in the lower frequency region. Hence for the remainder of the frequency range, real-valued processing suffices (assuming real-valued $m_{ij}$).

It is further noted that the equations above assume incoherent addition of the (HRTF) filtered signals of lf and lr. One possible extension would be to include the transmitted Inter-Channel Coherence (ICC) parameters of lf and lr (and of lf and rr) in the equations as well to account for front/rear correlation.

All processing steps described above can be combined in the parameter domain to result in a single, signal-domain 2x2 matrix:

$$\begin{bmatrix} l_b \\ r_b \end{bmatrix} = \begin{bmatrix} h_{11} & h_{12} \\ h_{21} & h_{22} \end{bmatrix} \begin{bmatrix} l_0 \\ r_0 \end{bmatrix} \tag{14},$$

with

$$h_{11} = m_{11}H_l(l) + m_{21}H_l(r) + m_{31}H_l(c) \qquad (15a)$$

$$h_{12} = m_{12}H_l(l) + m_{22}H_l(r) + m_{32}H_l(c) \qquad (15b)$$

$$h_{21} = m_{11}H_r(l) + m_{21}H_r(r) + m_{31}H_r(c) \qquad (15c)$$

$$h_{22} = m_{12}H_r(l) + m_{22}H_r(r) + m_{32}H_r(c) \qquad (15d).$$

The present invention essentially processes the binaural (that is, HRTF) information in the parameter domain, instead of in the frequency or time domain as in the Prior Art. In this way, significant computational savings may be obtained.

The spatial decoder device 2 according to the present invention shown merely by way of non-limiting example in Fig. 6 comprises a demultiplexer (Demux) unit 21, a downmix decoding unit 22, and a spatial/binaural decoder unit 23. The demultiplexer unit 21 and the downmix decoding unit 22 may be similar to the Prior Art demultiplexer unit 21' and the downmix decoding unit 22' shown in Fig. 3. The spatial decoder unit 23 of Fig. 6 is identical to the spatial decoder unit 23 of Fig. 5, with the exception of the number of downmix channels and associated transform units. As the spatial decoder device of Fig. 6 is arranged for a single downmix channel s, only a single transform unit 231 is provided while a decorrelation (D) unit 239 has been added for producing a decorrelated version D of the (transform domain) downmix signal S. The binaural parameters bp produced by the parameter conversion unit 234 typically differ from those in the embodiment of Fig. 5, as the spatial parameters sp associated with a single downmix channel s typically differ from those associated with two downmix channels.

In the configuration of Fig. 6, the input of the binaural decoder comprises a mono input signal s accompanied by spatial parameters sp. The binaural synthesis unit generates a stereo output signal with statistical properties that approximate those properties that would result from HRTF processing of the original 5.1 input, which can be described by:

$$l_b = H_l(lf) \otimes lf + H_l(rf) \otimes rf + H_l(lr) \otimes lr + H_l(Rr) \otimes Rr + H_l(c) \otimes c \qquad (16)$$

$$r_b = H_r(lf) \otimes lf + H_r(rf) \otimes rf + H_r(lr) \otimes lr + H_r(rr) \otimes rr + H_r(c) \otimes c \qquad (17)$$

Given the spatial parameters which describe statistical properties and interrelations of the channels *lf, rf, lr, rr* and c, and the parameters of the HRTF impulse responses, it is possible to estimate the statistical properties (that is, an approximation of the binaural parameters) of the binaural output pair $l_b$, $r_b$ as well. More specifically, the average energy (for each channel), the average phase difference and the coherence can be estimated and subsequently reinstated by means of decorrelation and matrixing of the mono input signal.

The binaural parameters comprise a (relative) level change for each of the two binaural output channels (and hence define a Channel Level Difference parameter), an (average) phase difference and a coherence measure (per transform domain time/frequency tile).

As a first step, the relative powers (with respect to the power of the mono input signal) of the five (or six) channel (5.1) signal are computed using the transmitted CLD parameters. The relative power of the left-front channel is given by:

$$\sigma_{lf}^2 = r_1(\mathrm{CLD}_{fs})r_1(\mathrm{CLD}_{fc})r_1(\mathrm{CLD}_f) \qquad (18),$$

with

$$r_1(\text{CLD}) = \frac{10^{\text{CLD}/10}}{1+10^{\text{CLD}/10}} \tag{19},$$

and

$$r_2(\text{CLD}) = \frac{1}{1+10^{\text{CLD}/10}} \tag{20}.$$

Similarly, the relative powers of the other channels are given by:

$$\sigma_{rf}^2 = r_1(\text{CLD}_{fs})r_1(\text{CLD}_{fc})r_2(\text{CLD}_f) \tag{21a}$$

$$\sigma_c^2 = r_1(\text{CLD}_{fs})r_2(\text{CLD}_{fc}) \tag{21b}$$

$$\sigma_{ls}^2 = r_2(\text{CLD}_{fs})r_1(\text{CLD}_s) \tag{21c}$$

$$\sigma_{rs}^2 = r_2(\text{CLD}_{fs})r_2(\text{CLD}_s) \tag{21d}$$

The expected value of the relative power $\sigma_L{}^2$ of the left binaural output channel (with respect to the mono input channel), the expected value of the relative power $\sigma_R{}^2$ of the right binaural output channel, and the expected value of the cross product $L_B R_B{}^*$ can then be calculated. The coherence of the binaural output ($\text{ICC}_B$) is then given by:

$$\text{ICC}_B = \frac{\left|\left\langle L_B R_B^* \right\rangle\right|}{\sigma_L \sigma_R} \tag{22}$$

and the average phase angle ($\text{IPD}_B$) is given by:

$$\text{IPD}_B = \arg\left(\left\langle L_B R_B^* \right\rangle\right) \tag{23}$$

The channel level difference ($\text{CLD}_B$) of the binaural output is given by:

$$\text{CLD}_B = 10\log_{10}\left(\frac{\sigma_L^2}{\sigma_R^2}\right) \tag{24}$$

Finally, the overall (linear) gain of the binaural output compared to the mono input, $g_B$, is given by:

$$g_B = \sqrt{\sigma_L^2 + \sigma_R^2} \tag{25}$$

The matrix coefficients required to re-instate the $\text{IPD}_B$, $\text{CLD}_B$, $\text{ICC}_B$ and $g_B$ parameters in the binaural matrix are simply obtained from a conventional parametric stereo decoder, extended with overall gains $g_B$:

$$h_{11} = g_B c_L \cos(\alpha + \beta) \exp(j\text{IPD}_B / 2) \qquad (26a)$$

$$h_{12} = g_B c_L \sin(\alpha + \beta) \exp(j\text{IPD}_B / 2) \qquad (26b)$$

$$h_{21} = g_B c_R \cos(-\alpha + \beta) \exp(-j\text{IPD}_B / 2) \qquad (26c)$$

$$h_{22} = g_B c_R \sin(-\alpha + \beta) \exp(-j\text{IPD}_B / 2) \qquad (26d)$$

with

$$\alpha = 0.5 \arccos(\text{ICC}_B) \qquad (27)$$

$$\beta = \arctan\left(\frac{c_R - c_L}{c_R + c_L} \tan(\alpha)\right) \qquad (28)$$

$$c_L = \sqrt{\frac{10^{\text{CLD}_B / 10}}{1 + 10^{\text{CLD}_B / 10}}} \qquad (29)$$

$$c_R = \sqrt{\frac{1}{1 + 10^{\text{CLD}_B / 10}}} \qquad (30)$$

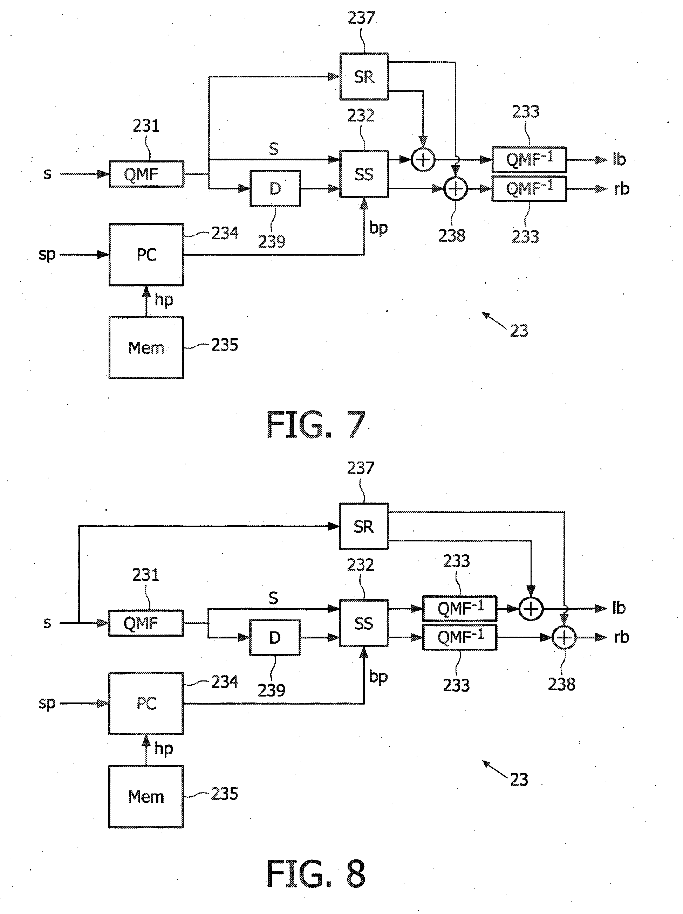

Further embodiments of the spatial decoder unit of the present invention may contain a reverberation unit. It has been found that adding reverberation improves the perceived distance when binaural sound is produced. For this reason, the spatial decoder unit 23 of Fig. 7 is provided with a stereo reverberation unit 237 connected in parallel with the spatial synthesis unit 232. The stereo reverberation unit 237 of Fig. 7 receives the QMF transform domain single downmix signal S and outputs two reverberation signals, which are added to the transform domain binaural signals (channels Lb and Lr in Fig. 6) by addition units 238. The combined signals are then inversely transformed by inverse transform units 233 before being output.

In the embodiment of Fig. 8, the stereo reverberation unit 237 is arranged for producing a reverberation in the time domain and receives the time domain single downmix signal s. The stereo reverberation unit 237 outputs time domain reverberation signals, which are added to the time domain signals of the binaural channels lb and rb by the addition units 238. Either embodiment provides a suitable reverberation.

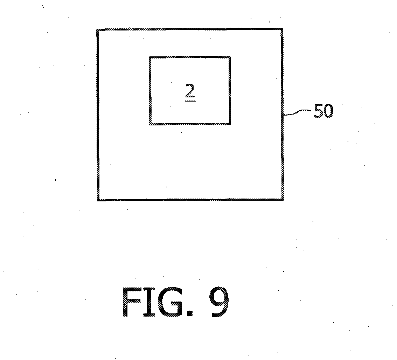

The present invention additionally provides a consumer device, such as a hand-held consumer device, and an audio system comprising a spatial decoder unit or spatial decoder device as defined above. The hand-held consumer device may be constituted by an MP3 player or similar device. A consumer device is schematically illustrated in Fig. 9. The consumer device 50 is shown to comprise a spatial decoder device 2 according to the present invention (see Fig. 6).

The present invention is based upon the insight that the computational complexity of a combined spatial decoder device and a binaural synthesis device may be significantly reduced by modifying the spatial parameters in accordance with the binaural information. This allows the spatial decoder device to carry out spatial decoding and perceptual transfer function processing effectively in the same signal processing operation, while avoiding the introduction of any artifacts. It is noted that any terms used in this document should not be construed so as to limit the scope of the present invention. In particular, the words "comprise(s)" and "comprising" are not meant to exclude any elements not specifically stated. Single (circuit) elements may be substituted with multiple (circuit) elements or with their equivalents.

It will be understood by those skilled in the art that the present invention is not limited to the embodiments illustrated above and that many modifications and additions may be made without departing from the scope of the invention as defined in the appending claims.

**Claims**

1. A spatial decoder unit (23) for producing a pair of binaural output channels (lb, rb) using spatial parameters (sp) and one audio downmix input channel (s), the device **characterized by** comprising:

   - a parameter conversion unit (234) for converting the spatial parameters (sp) into binaural parameters (bp) using parameterized perceptual transfer functions (hp), the binaural parameters depending on both the spatial parameters (sp) and the parameterized perceptual transfer functions;
   - one transform unit for transforming the audio downmix input channel into a transformed audio input channel in the QMF domain,
   - a decorrelation unit (239) for generating a decorrelated version of the transformed audio input channel;
   - a spatial synthesis unit (232) for synthesizing a pair of transformed binaural channels (Lb, Rb) as:

$$\begin{bmatrix} Lb[k,m] \\ Rb[k,m] \end{bmatrix} = H_k \begin{bmatrix} L[k,m] \\ R[k,m] \end{bmatrix} = \begin{bmatrix} h_{11} & h_{12} \\ h_{21} & h_{22} \end{bmatrix}_k \begin{bmatrix} S[k,m] \\ D[k,m] \end{bmatrix}$$

where index $k$ denotes a QMF hybrid frequency band index and index $m$ denotes a QMF slot time index, with the parameters $h_{ij}$ of the matrix $H_k$ being determined by the binaural parameters and S[k,m] is the transformed audio input channel and D[k,m] is the decorrelated version of the transformed audio input channel;
   - a pair of inverse transform units for inversely transforming the synthesized binaural channels into the pair of binaural output channels; wherein the matrix coefficients are given by:

$$h_{11} = g_B c_L \cos(\alpha + \beta) \exp(j\mathrm{IPD}_B / 2)$$

$$h_{12} = g_B c_L \sin(\alpha + \beta) \exp(j\mathrm{IPD}_B / 2)$$

$$h_{21} = g_B c_R \cos(-\alpha + \beta) \exp(-j\mathrm{IPD}_B / 2)$$

$$h_{22} = g_B c_R \sin(-\alpha + \beta) \exp(-j\mathrm{IPD}_B / 2)$$

where

$$g_B = \sqrt{\sigma_L^2 + \sigma_R^2}$$

$$\alpha = 0.5 \arccos(\mathrm{ICC}_B)$$

$$\beta = \arctan\left( \frac{c_R - c_L}{c_R + c_L} \tan(\alpha) \right)$$

$$c_L = \sqrt{\frac{10^{\mathrm{CLD}_B/10}}{1+10^{\mathrm{CLD}_B/10}}}$$

$$c_R = \sqrt{\frac{1}{1+10^{\mathrm{CLD}_B/10}}}$$

with

$$\mathrm{IPD}_B = \arg\left(\left\langle L_B R_B^* \right\rangle\right)$$

$$\mathrm{ICC}_B = \frac{\left|\left\langle L_B R_B^* \right\rangle\right|}{\sigma_L \sigma_R}$$

$$\mathrm{CLD}_B = 10\log_{10}\left(\frac{\sigma_L^2}{\sigma_R^2}\right)$$

where arg denotes an argument function, | | denotes an absolute value function, and * denotes complex conjugate, and

means for calculating the relative powers $\sigma_{lf}^2, \sigma_{rf}^2, \sigma_c^2, \sigma_{ls}^2,$ and $\sigma_{rs}^2$ of the five channels with respect to the one audio downmix input channel from the spatial parameters as

$$\sigma_{lf}^2 = r_1(\mathrm{CLD}_{fs})r_1(\mathrm{CLD}_{fc})r_1(\mathrm{CLD}_f),$$

$$\sigma_{rf}^2 = r_1(\mathrm{CLD}_{fs})r_1(\mathrm{CLD}_{fc})r_2(\mathrm{CLD}_f),$$

$$\sigma_c^2 = r_1(\mathrm{CLD}_{fs})r_2(\mathrm{CLD}_{fc}),$$

$$\sigma_{ls}^2 = r_2(\mathrm{CLD}_{fs})r_1(\mathrm{CLD}_s),$$

$$\sigma_{rs}^2 = r_2(\mathrm{CLD}_{fs})r_2(\mathrm{CLD}_s),$$

with

$$r_1(\mathrm{CLD}) = \frac{10^{\mathrm{CLD}/10}}{1+10^{\mathrm{CLD}/10}},$$

and

$$r_2(\text{CLD}) = \frac{1}{1+10^{\text{CLD}/10}} \quad ,$$

and wherein

$\text{CLD}_{fs}$ is a parameter of the spatial parameters defining a level difference for front channels versus rear channels;
$\text{CLD}_{fc}$ is a parameter of the spatial parameters defining a level difference for front channels versus a center channel;
$\text{CLD}_f$ is a parameter of the spatial parameters defining a level difference for the front left channel versus the front right channel; and
$\text{CLD}_s$ is a parameter of the spatial parameters defining a level difference for the rear left channel versus the rear right channel; and

means for calculating, based on the relative powers $\sigma_{lf}^2, \sigma_{rf}^2, \sigma_c^2, \sigma_{ls}^2$, and $\sigma_{rs}^2$ , the expected value of

the relative power $\sigma_L^2$ of the left binaural output channel, and the expected value of the relative power $\sigma_R^2$ of the right binaural output channel and of the expected value of the cross product $L_B R_B$.

2. A spatial decoder unit (23) for producing a pair of binaural output channels (lb, rb) using spatial parameters (sp) and two audio input channels (l, r), the device **characterized by** comprising:

- a parameter conversion unit (234) for converting the spatial parameters (sp) into binaural parameters (bp) using parameterized perceptual transfer functions (hp), the binaural parameters depending on both the spatial parameters (sp) and the parameterized perceptual transfer functions;
- two transform units for transforming the two audio input channels into transformed audio input channels in the QMF domain,
- a spatial synthesis unit (232) for synthesizing a pair of transformed binaural channels (Lb, Rb) as:

$$\begin{bmatrix} Lb[k,m] \\ Rb[k,m] \end{bmatrix} = H_k \begin{bmatrix} L[k,m] \\ R[k,m] \end{bmatrix} = \begin{bmatrix} h_{11} & h_{12} \\ h_{21} & h_{22} \end{bmatrix}_k \begin{bmatrix} L[k,m] \\ R[k,m] \end{bmatrix}$$

where index $k$ denotes a QMF hybrid frequency band index and index m denotes a QMF slot time index, with the parameters $h_{ij}$ of the matrix $H_k$ being determined by the binaural parameters and L[k,m] and R[k,m] are QMF transformed audio input signals; and
- a pair of inverse transform units for inversely transforming the synthesized binaural channels into the pair of binaural output channels; wherein
the matrix coefficients are given by:

$$h_{11} = m_{11} H_l(l) + m_{21} H_l(r) + m_{31} H_l(c)$$

$$h_{12} = m_{12} H_l(l) + m_{22} H_l(r) + m_{32} H_l(c)$$

$$h_{21} = m_{11} H_r(l) + m_{21} H_r(r) + m_{31} H_r(c)$$

$$h_{22} = m_{12} H_r(l) + m_{22} H_r(r) + m_{32} H_r(c)$$

where

$$H_l(c) = P_l(c)e^{-j\phi(c)/2}$$

$$H_r(c) = Pr(c)e^{-j\phi(c)/2}$$

$$H_l(l) = \sqrt{w_{lf}^2 P_l^2(lf) + w_{lr}^2 P_l^2(lr)}$$

$$H_r(l) = e^{-j(w_{lf}^2\phi(lf)+w_{lr}^2\phi(lr))}\sqrt{w_{lf}^2 P_r^2(lf) + w_{lr}^2 P_r^2(lr)}$$

$$H_l(r) = e^{+j(w_{rf}^2\phi(rf)+w_{rs}^2\phi(rr))}\sqrt{w_{rf}^2 P_l^2(rf) + w_{rr}^2 P_l^2(rs)} \; ;$$

and

$$H_r(r) = \sqrt{w_{rf}^2 P_r^2(rf) + w_{rr}^2 P_r^2(rr)}$$

with

$$w_{lf}^2 = \frac{10^{CLD_l/10}}{1+10^{CLD_l/10}}$$

$$w_{lr}^2 = \frac{1}{1+10^{CLD_l/10}}$$

$$w_{rf}^2 = \frac{10^{CLD_r/10}}{1+10^{CLD_r/10}}$$

$$w_{rr}^2 = \frac{1}{1+10^{CLD_r/10}}$$

where

$CLD_l$ is a parameter of the spatial parameters defining a level difference for a left front channel versus a left rear channel;
$CLD_r$ is a parameter of the spatial parameters defining a level difference for a right front channel versus a right rear channel;

and

$P_l(c)$ is the average power level per frequency band of a parameterized perceptual transfer function for a left binaural channel from a center channel;
$P_r(c)$ is the average power level per frequency band of the parameterized perceptual transfer function for a right binaural channel from the center channel;
$P_l(IF)$ is the average level per frequency band of a parameterized perceptual transfer function for the left binaural channel from the left front channel;

$P_l(rf)$ is the average level per frequency band of a parameterized perceptual transfer function for the left binaural channel from the right front channel;

$P_l(lR)$ is the average level per frequency band of a parameterized perceptual transfer function for the left binaural channel from the left rear channel;

$P_l(rr)$ is the average level per frequency band of a parameterized perceptual transfer function for the left binaural channel from the right rear channel;

$P_r(lf)$ is the average level per frequency band of a parameterized perceptual transfer function for the right binaural channel from the left front channel;

$P_r(rf)$ is the average level per frequency band of a parameterized perceptual transfer function for the right binaural channel from the right front channel;

$P_r(lr)$ is the average level per frequency band of a parameterized perceptual transfer function for the right binaural channel from the left rear channel;

$P_r(rr)$ is the average level per frequency band of a parameterized perceptual transfer function for the right binaural channel from the right rear channel;

$\varphi_{(c)}$ is the average phase difference per frequency band between the parameterized perceptual transfer function for the left binaural channel and the parameterized perceptual transfer function for the right binaural channel from the center channel;

$\varphi_{(lf)}$ is the average phase difference per frequency band between the parameterized perceptual transfer function for the left binaural channel and the parameterized perceptual transfer function for the right binaural channel from the left front channel;

$\varphi_{(rf)}$ is the average phase difference per frequency band between the parameterized perceptual transfer function for the left binaural channel and the parameterized perceptual transfer function for the right binaural channel from the right front channel;

$\varphi_{(lr)}$ is the average phase difference per frequency band between the parameterized perceptual transfer function for the left binaural channel and the parameterized perceptual transfer function for the right binaural channel from the left rear channel;

$\varphi_{(rr)}$ is the average phase difference per frequency band between the parameterized perceptual transfer function for the left binaural channel and the parameterized perceptual transfer function for the right binaural channel from the right rear channel;

and $m_{11}, m_{21}, m_{31}, m_{12}, m_{22}, m_{32}, m_{13}, m_{23}$, and $m_{33}$ depend on the spatial parameters in the same manner as in a two-to-three upmix unit of a 5.1 MPEG surround decoder.

3. A spatial decoder device (2) for producing a pair of binaural output channels (lb, rb) from an input bitstream (bs), the device comprising:

- a demultiplexer unit (21) for demultiplexing the input bitstream into at least one downmix channel and spatial parameters (sp),
- a downmix decoder unit (22) for decoding the at least one downmix channel (s), and
- a spatial decoder unit (23) according to claim 1 or 2.

4. The spatial decoder device of claim 2, wherein the spatial decoder unit (23) comprises a reverberation unit (237).

5. An audio system, comprising a spatial decoder unit (23) according to claim 1 or 2 and/or a spatial decoder device (2) according to claim 3.

6. A consumer device, comprising a spatial decoder unit (23) according to claim 1 or 2 and/or a spatial decoder device (2) according to claim 3.

7. A method of producing a pair of binaural output channels (lb, rb) using spatial parameters (sp) and one downmix input channel (s,), the method being **characterized by** comprising the steps of:

- converting the spatial parameters (sp) into binaural parameters (bp) using parameterized perceptual transfer functions (hp), the binaural parameters depending on both the spatial parameters (sp) and the parameterized perceptual transfer functions; - transforming the audio downmix input channel into a transformed audio input channel in the QMF domain,
- generating a decorrelated version of the transformed audio input channel;
- synthesizing a pair of transformed binaural channels (Lb, Rb) as

$$\begin{bmatrix} Lb[k,m] \\ Rb[k,m] \end{bmatrix} = H_k \begin{bmatrix} L[k,m] \\ R[k,m] \end{bmatrix} = \begin{bmatrix} h_{11} & h_{12} \\ h_{21} & h_{22} \end{bmatrix}_k \begin{bmatrix} S[k,m] \\ D[k,m] \end{bmatrix}$$

where index $k$ denotes a QMF hybrid frequency band index and index $m$ denotes a QMF slot time index, with the parameters $h_{ij}$ of the matrix $H_k$ being are determined by the binaural parameters and S[k,m] is the QMF transformed audio input channel and D[k,m] is the decorrelated version of the transformed audio input channel;
- inversely transforming the transformed binaural channels (Lb, Rb) into the pair of binaural output channels (lb, rb) ;
and wherein
the matrix coefficients are given by:

$$h_{11} = g_B c_L \cos(\alpha + \beta) \exp(j\mathrm{IPD}_B / 2)$$

$$h_{12} = g_B c_L \sin(\alpha + \beta) \exp(j\mathrm{IPD}_B / 2)$$

$$h_{21} = g_B c_R \cos(-\alpha + \beta) \exp(-j\mathrm{IPD}_B / 2)$$

$$h_{22} = g_B c_R \sin(-\alpha + \beta) \exp(-j\mathrm{IPD}_B / 2)$$

where

$$g_B = \sqrt{\sigma_L^2 + \sigma_R^2}$$

$$\alpha = 0.5 \arccos(\mathrm{ICC}_B)$$

$$\beta = \arctan\left( \frac{c_R - c_L}{c_R + c_L} \tan(\alpha) \right)$$

$$c_L = \sqrt{\frac{10^{\mathrm{CLD}_B / 10}}{1 + 10^{\mathrm{CLD}_B / 10}}}$$

$$c_R = \sqrt{\frac{1}{1 + 10^{\mathrm{CLD}_B / 10}}}$$

with

$$\mathrm{IPD}_B = \arg\left(\left\langle L_B R_B^* \right\rangle\right)$$

$$ICC_B = \frac{\left|\left\langle L_B R_B^* \right\rangle\right|}{\sigma_L \sigma_R}$$

$$CLD_B = 10\log_{10}\left(\frac{\sigma_L^2}{\sigma_R^2}\right)$$

where arg denotes an argument function, | | denotes an absolute value function, and * denotes complex conjugate, and

calculating the relative powers $\sigma_{lf}^2, \sigma_{rf}^2, \sigma_c^2, \sigma_{ls}^2$, and $\sigma_{rs}^2$ of the five channels with respect to the one audio downmix input channel from the spatial parameters as

$$\sigma_{lf}^2 = r_1(CLD_{fs})r_1(CLD_{fc})r_1(CLD_f),$$

$$\sigma_{rf}^2 = r_1(CLD_{fs})r_1(CLD_{fc})r_2(CLD_f),$$

$$\sigma_c^2 = r_1(CLD_{fs})r_2(CLD_{fc}),$$

$$\sigma_{ls}^2 = r_2(CLD_{fs})r_1(CLD_s),$$

$$\sigma_{rs}^2 = r_2(CLD_{fs})r_2(CLD_s),$$

with

$$r_1(CLD) = \frac{10^{CLD/10}}{1+10^{CLD/10}},$$

and

$$r_2(CLD) = \frac{1}{1+10^{CLD/10}},$$

and wherein

$CLD_{fs}$ is a parameter of the spatial parameters defining a level difference for front channels versus rear channels;
$CLD_{fc}$ is a parameter of the spatial parameters defining a level difference for front channels versus a center channel;
$CLD_f$ is a parameter of the spatial parameters defining a level difference for the front left channel versus the front right channel; and
$CLD_s$ is a parameter of the spatial parameters defining a level difference for the rear left channel versus the rear right channel; and

calculating, based on the relative powers $\sigma_{lf}^2, \sigma_{rf}^2, \sigma_c^2, \sigma_{ls}^2$, and $\sigma_{rs}^2$, the expected value of the relative power

$\sigma_L^2$ of the left binaural output channel, and the expected value of the relative power $\sigma_R^2$ of the right binaural output channel and of the expected value of the cross product $L_B R_B$.

8. A method of producing a pair of binaural output channels (lb, rb) using spatial parameters (sp) and two audio input channels (l, r), the method **characterized by** comprising the steps of:

- converting the spatial parameters (sp) into binaural parameters (bp) using parameterized perceptual transfer functions (hp), the binaural parameters depending on both the spatial parameters (sp) and the parameterized perceptual transfer functions;
- transforming the two audio input channels into transformed audio input channels in the QMF domain,
- synthesizing a pair of transformed binaural channels (Lb, Rb) as:

$$\begin{bmatrix} Lb[k,m] \\ Rb[k,m] \end{bmatrix} = H_k \begin{bmatrix} L[k,m] \\ R[k,m] \end{bmatrix} = \begin{bmatrix} h_{11} & h_{12} \\ h_{21} & h_{22} \end{bmatrix}_k \begin{bmatrix} L[k,m] \\ R[k,m] \end{bmatrix}$$

where index $k$ denotes a QMF hybrid frequency band index and index $m$ denotes a QMF slot time index, with the parameters $h_{ij}$ of the matrix $H_k$ being determined by the binaural parameters and L[k,m] and R[k,m] are QMF transformed audio input signals; and
- inversely transforming the synthesized binaural channels into the pair of binaural output channels; wherein the matrix coefficients are given by:

$$h_{11} = m_{11} H_l(l) + m_{21} H_l(r) + m_{31} H_l(c)$$

$$h_{12} = m_{12} H_l(l) + m_{22} H_l(r) + m_{32} H_l(c)$$

$$h_{21} = m_{11} H_r(l) + m_{21} H_r(r) + m_{31} H_r(c)$$

$$h_{22} = m_{12} H_r(l) + m_{22} H_r(r) + m_{32} H_r(c)$$

where

$$H_l(c) = P_l(c) e^{-j\phi(c)/2}$$

$$H_r(c) = Pr(c) e^{-j\phi(c)/2}$$

$$H_l(l) = \sqrt{w_{lf}^2 P_l^2(lf) + w_{lr}^2 P_l^2(lr)}$$

$$H_r(l) = e^{-j(w_{lf}^2 \phi(lf) + w_{ls}^2 \phi(lr))} \sqrt{w_{lf}^2 P_r^2(lf) + w_{lr}^2 P_r^2(lr)}$$

$$H_l(r) = e^{+j(w_{rf}^2 \phi(rf) + w_{rs}^2 \phi(rr))} \sqrt{w_{rf}^2 P_l^2(rf) + w_{rr}^2 P_l^2(rs)} \; ;$$

and

$$H_r(r) = \sqrt{w_{rf}^2 P_r^2(rf) + w_{rr}^2 P_r^2(rr)}$$

with

$$w_{lf}^2 = \frac{10^{CLD_l/10}}{1 + 10^{CLD_l/10}}$$

$$w_{lr}^2 = \frac{1}{1 + 10^{CLD_l/10}}$$

$$w_{rf}^2 = \frac{10^{CLD_r/10}}{1 + 10^{CLD_r/10}}$$

$$w_{rr}^2 = \frac{1}{1 + 10^{CLD_r/10}}$$

where

$CLD_l$ is a parameter of the spatial parameters defining a level difference for a left front channel versus a left rear channel;
$CLD_r$ is a parameter of the spatial parameters defining a level difference for a right front channel versus a right rear channel;

and

$P_l(c)$ is the average power level per frequency band of a parameterized perceptual transfer function for a left binaural channel from a center channel;
$P_r(c)$ is the average power level per frequency band of the parameterized perceptual transfer function for a right binaural channel from the center channel;
$P_l(lF)$ is the average level per frequency band of a parameterized perceptual transfer function for the left binaural channel from the left front channel;
$P_l(rf)$ is the average level per frequency band of a parameterized perceptual transfer function for the left binaural channel from the right front channel;
$P_l(lr)$ is the average level per frequency band of a parameterized perceptual transfer function for the left binaural channel from the left rear channel;
$P_l(rr)$ is the average level per frequency band of a parameterized perceptual transfer function for the left binaural channel from the right rear channel;
$P_r(lf)$ is the average level per frequency band of a parameterized perceptual transfer function for the right binaural channel from the left front channel;
$P_r(rf)$ is the average level per frequency band of a parameterized perceptual transfer function for the right binaural channel from the right front channel;
$P_r(lr)$ is the average level per frequency band of a parameterized perceptual transfer function for the right binaural channel from the left rear channel;
$P_r(rr)$ is the average level per frequency band of a parameterized perceptual transfer function for the right binaural channel from the right rear channel;
$\varphi_{(c)}$ is the average phase difference per frequency band between the parameterized perceptual transfer function for the left binaural channel and the parameterized perceptual transfer function for the right binaural channel from the center channel;
$\varphi_{(lf)}$ is the average phase difference per frequency band between the parameterized perceptual transfer function for the left binaural channel and the parameterized perceptual transfer function for the right binaural channel from the left front channel;
$\varphi_{(rf)}$ is the average phase difference per frequency band between the parameterized perceptual transfer function for the left binaural channel and the parameterized perceptual transfer function for the right binaural channel from the right front channel;

$\varphi_{(lr)}$ is the average phase difference per frequency band between the parameterized perceptual transfer function for the left binaural channel and the parameterized perceptual transfer function for the right binaural channel from the left rear channel;

$\varphi_{(rr)}$ is the average phase difference per frequency band between the parameterized perceptual transfer function for the left binaural channel and the parameterized perceptual transfer function for the right binaural channel from the right rear channel;

and $m_{11}$, $m_{21}$, $m_{31}$, $m_{12}$, $m_{22}$, $m_{32}$, $m_{13}$, $m_{23}$, and $m_{33}$ depend on the spatial parameters in the same manner as in a two-to-three upmix unit of a 5.1 MPEG surround decoder.

9. A computer program product for carrying out the method according to claim 7 or 8.

**Patentansprüche**

1. Eine räumliche Decodereinheit (23) zum Schaffen ein Paar binauraler Ausgangskanäle (lb, rb) unter Verwendung räumlicher Parameter (sp) und eines Audio-Heruntermischeingangskanals (s), wobei die Einrichtung **dadurch gekennzeichnet ist, dass** sie Folgendes umfasst:

- eine Parameterumwandlungseinheit (234) zum Umwandeln der räumlichen Parameter (sp) in binaurale Parameter (bp), unter Verwendung parametrisierter perzeptueller Übertragungsfunktionen (hp), wobei die binauralen Parameter von den räumlichen Parametern (sp) sowie von den parametrisierten perzeptuellen Übertragungsfunktionen abhängig sind;
- eine Transformationseinheit zum Transformieren des Audio-Heruntermischeingangskanals in einen transformierten Audio-Eingangskanal in der QMF-Domäne,
- eine Dekorrelationseinheit (239) zum Erzeugen einer dekorrelierten Version des transformierten Audio-Eingangskanals;
- eine räumliche Syntheseeinheit (232) zum Synthetisieren eines Paares transformierter binauraler Kanäle (Lb, Rb) als:

$$\begin{bmatrix} Lb[k,m] \\ Rb[k,m] \end{bmatrix} = H_k \begin{bmatrix} L[k,m] \\ R[k,m] \end{bmatrix} = \begin{bmatrix} h_{11} & h_{12} \\ h_{21} & h_{22} \end{bmatrix}_k \begin{bmatrix} S[k,m] \\ D[k,m] \end{bmatrix}$$

wobei der Index k einen QMF Hybridfrequenzbandindex bezeichnet und Index m einen QMF Schlitzzeitindex bezeichnet, wobei die Parameter $h_{ij}$ der Matrix $H_k$ durch die binauralen Parameter bestimmt werden und S[k,m] der transformierte Audio-Eingangskanal und D[k,m] die dekorrelierte Version des transformierten Audio-Eingangskanals ist;
- ein Paar invertierte Transformationseinheiten, die invertiert die synthetisierten binauralen Kanäle in ein Paar binauraler Ausgangskanäle transformieren; wobei die Matrixkoeffizienten gegeben werden durch:

$$h_{11} = g_B c_L \cos(\alpha + \beta) \exp(j\text{IPD}_B / 2)$$

$$h_{12} = g_B c_L \sin(\alpha + \beta) \exp(j\text{IPD}_B / 2)$$

$$h_{21} = g_B c_R \cos(-\alpha + \beta) \exp(-j\text{IPD}_B / 2)$$

$$h_{22} = g_B c_R \sin(-\alpha + \beta) \exp(-j\text{IPD}_B / 2)$$

wobei

$$g_B = \sqrt{\sigma_L^2 + \sigma_R^2}$$

$$\alpha = 0.5\,\mathrm{arccos}(\mathrm{ICC}_B)$$

$$\beta = \arctan\left(\frac{c_R - c_L}{c_R + c_L}\tan(\alpha)\right)$$

$$c_L = \sqrt{\frac{10^{\mathrm{CLD}_B/10}}{1 + 10^{\mathrm{CLD}_B/10}}}$$

$$c_R = \sqrt{\frac{1}{1 + 10^{\mathrm{CLD}_B/10}}}$$

mit

$$\mathrm{IPD}_B = \arg\left(\langle L_B R_B^* \rangle\right)$$

$$\mathrm{ICC}_B = \frac{\left|\langle L_B R_B^* \rangle\right|}{\sigma_L \sigma_R}$$

$$\mathrm{CLD}_B = 10\log_{10}\left(\frac{\sigma_\mathrm{L}^2}{\sigma_\mathrm{R}^2}\right)$$

wobei arg eine Argumentfunktion bezeichnet, | | eine Absolutwertfunktion bezeichnet und * ein komplexes Konjugieren bezeichnet, und

- Mittel zum Berechnen der relativen Potenzen $\sigma_{lf}^2, \sigma_{rf}^2, \sigma_c^2, \sigma_{ls}^2$, und, $\sigma_{rs}^2$ der fünf Kanäle gegenüber einem Audio-Heruntermischeingangskanal von den räumlichen Parametern wie

$$\sigma_{lf}^2 = r_1(\mathrm{CLD}_{fs})r_1(\mathrm{CLD}_{fc})r_1(\mathrm{CLD}_f),$$

$$\sigma_{rf}^2 = r_1(\mathrm{CLD}_{fs})r_1(\mathrm{CLD}_{fc})r_2(\mathrm{CLD}_f),$$

$$\sigma_c^2 = r_1(\mathrm{CLD}_{fs})r_2(\mathrm{CLD}_{fc}),$$

$$\sigma_{ls}^2 = r_2(\mathrm{CLD}_{fs})r_1(\mathrm{CLD}_s),$$

$$\sigma_{rs}^2 = r_2(\mathrm{CLD}_{fs})r_2(\mathrm{CLD}_s),$$

mit

$$r_1(\mathrm{CLD}) = \frac{10^{\mathrm{CLD}/10}}{1+10^{\mathrm{CLD}/10}} \quad ,$$

und

$$r_2(\mathrm{CLD}) = \frac{1}{1+10^{\mathrm{CLD}/10}} \quad ,$$

und wobei

CLDfs ein Parameter der räumlichen Parameter ist, der eine Pegeldifferenz für Frontkanäle und Rückkanäle definiert;
CLDfe ein Parameter der räumlichen Parameter ist, der eine Pegeldifferenz für Frontkanäle gegen einen Zentralkanal definiert;
CLDf ein Parameter der räumlichen Parameter ist, der eine Pegeldifferenz für den linken Frontkanal gegen den rechten Frontkanal definiert; und
CLDs ein Parameter der räumlichen Parameter ist, der eine Pegeldifferenz für den linken Rückkanal gegen den rechten Rückkanal definiert; und

Mittel zum Berechnen, auf Basis der relativen Potenzen $\sigma_{lf}^2, \sigma_{rf}^2, \sigma_c^2, \sigma_{ls}^2,$ *und,* $,\sigma_{rs}^2,$ des erwarteten Wertes der relativen Potenz $\sigma_L^2$ des linken binauralen Ausgangskanals, und des erwarteten Wertes der relativen Potenz $\sigma_R^2$ des rechten binauralen Ausgangskanals und des erwarteten Wertes des Kreuzproduktes $L_B R_B$.

2. Räumliche Decodereinheit (23) zum Schaffen eines Paares binauraler Ausgangskanäle (lb, rb) unter Verwendung räumlicher Parameter (sp) und zweiter Audio-Eingangskanäle (l, r), wobei die Einrichtung **dadurch gekennzeichnet ist, dass** sie Folgendes umfasst:

- eine Parameterumwandlungseinheit (234) zum Umwandeln der räumlichen Parameter (sp) in binaurale Parameter (bp) unter Verwendung parametrisierter perzeptueller Übertragungsfunktionen (hp), wobei die binauralen Parameter von den räumlichen Parametern (sp) sowie von den parametrisierten perzeptuellen Übertragungsfunktionen abhängig sind;
- zwei Transformationseinheiten zum Transformieren der zwei Audio-Eingangskanäle in transformierte Audio-Eingangskanäle in der QMF-Domäne,
- eine räumliche Syntheseeinheit (232) zum Synthetisieren eines Paares transformierter binauraler Kanäle (Lb, Rb) als:

$$\begin{bmatrix} Lb[k,m] \\ Rb[k,m] \end{bmatrix} = H_k \begin{bmatrix} L[k,m] \\ R[k,m] \end{bmatrix} = \begin{bmatrix} h_{11} & h_{12} \\ h_{21} & h_{22} \end{bmatrix}_k \begin{bmatrix} S[k,m] \\ D[k,m] \end{bmatrix}$$

wobei der Index k einen QMF Hybridfrequenzbandindex bezeichnet und Index m einen QMF Schlitzzeitindex bezeichnet, wobei die Parameter $h_{ij}$ der Matrix $H_k$ durch die binauralen Parameter bestimmt werden und L[k,m] und R[k,m] QMF transformierte Audio-Eingangssignale sind; und
- ein Paar invertierter Transformationseinheiten zur invertierten Transformation der synthetisierten binauralen Kanäle in ein Paar binauraler Ausgangskanäle; wobei die Matrixkoeffizienten gegeben werden durch:

$$h_{11} = m_{11}H_l(l) + m_{21}H_l(r) + m_{31}H_l(c)$$

$$h_{12} = m_{12}H_l(l) + m_{22}H_l(r) + m_{32}H_l(c)$$

$$h_{21} = m_{11}H_r(l) + m_{21}H_r(r) + m_{31}H_r(c)$$

$$h_{22} = m_{12}H_r(l) + m_{22}H_r(r) + m_{32}H_r(c)$$

wobei

$$H_l(c) = P_l(c)e^{-j\phi(c)/2}$$

$$H_r(c) = Pr(c)e^{-j\phi(c)/2}$$

$$H_l(l) = \sqrt{w_{lf}^2 P_l^2(lf) + w_{lr}^2 P_l^2(lr)}$$

$$H_r(l) = e^{-j(w_{lf}^2\phi(lf)+w_{ls}^2\phi(lr))}\sqrt{w_{lf}^2 P_r^2(lf) + w_{lr}^2 P_r^2(lr)}$$

$$H_l(r) = e^{+j(w_{rf}^2\phi(rf)+w_{rs}^2\phi(rr))}\sqrt{w_{rf}^2 P_l^2(rf) + w_{rr}^2 P_l^2(rs)} \; ;$$

$$H_r(r) = \sqrt{w_{rf}^2 P_r^2(rf) + w_{rr}^2 P_r^2(rr)}$$

mit

$$w_{lf}^2 = \frac{10^{CLD_l/10}}{1+10^{CLD_l/10}}$$

$$w_{lr}^2 = \frac{1}{1+10^{CLD_l/10}}$$

$$w_{rf}^2 = \frac{10^{CLD_r/10}}{1+10^{CLD_r/10}}$$

$$w_{rr}^2 = \frac{1}{1+10^{CLD_r/10}}$$

wobei

$CLD_l$ ein Parameter der räumlichen Parameter ist, der eine Pegeldifferenz für einen linken Frontkanal gegen einen linken Rückkanal definiert;

$CLD_r$ ein Parameter der räumlichen Parameter ist, der eine Pegeldifferenz für einen rechten Frontkanal gegen einen rechten Rückkanal definiert;

und

$P_l(1f)$ der mittlere Potenzpegel je Frequenzband einer parametrisierten perzeptuellen Übertragungsfunktion für einen linken binauralen Kanal von einem Zentralkanal ist;

$P_r(c)$ der mittlere Potenzpegel je Frequenzband der parametrisierten perzeptuellen Übertragungsfunktion für einen rechten binauralen Kanal von dem Zentralkanal ist;

$P_l(lf)$ der mittlere Pegel je Frequenzband einer parametrisierten perzeptuellen Übertragungsfunktion für den linken binauralen Kanal von dem linken Frontkanal ist;

$P_l(rf)$ der mittlere Pegel je Frequenzband einer parametrisierten perzeptuellen Übertragungsfunktion für den linken binauralen Kanal von dem rechten Frontkanal ist;

$P_l(lr)$ der mittlere Pegel je Frequenzband einer parametrisierten perzeptuellen Übertragungsfunktion für den linken binauralen Kanal von dem linken Rückkanal ist;

$P_l(rr)$ der mittlere Pegel je Frequenzband einer parametrisierten perzeptuellen Übertragungsfunktion für den linken binauralen Kanal von dem rechten Rückkanal ist;

$P_r(lf)$ der mittlere Pegel je Frequenzband einer parametrisierten perzeptuellen Übertragungsfunktion für den rechten binauralen Kanal von dem linken Frontkanal ist;

$P_r(rf)$ der mittlere Pegel je Frequenzband einer parametrisierten perzeptuellen Übertragungsfunktion für den rechten binauralen Kana von dem rechten Frontkanal ist;

$P_r(lr)$ der mittlere Pegel je Frequenzband einer parametrisierten perzeptuellen Übertragungsfunktion für den rechten binauralen Kanal von dem linken Rückkanal ist;

$P_r(rr)$ der mittlere Pegel je Frequenzband einer parametrisierten perzeptuellen Übertragungsfunktion für den rechten binauralen Kanal von dem rechten Rückkanal ist;

$\varphi(c)$ die mittlere Phasendifferenz je Frequenzband zwischen der parametrisierten perzeptuellen Übertragungsfunktion für den linken binauralen Kanal und der parametrisierten perzeptuellen Übertragungsfunktion für den rechten binauralen Kanal von dem Zentralkanal ist;

$\varphi(lf)$ die mittlere Phasendifferenz je Frequenzband zwischen der parametrisierten perzeptuellen Übertragungsfunktion für den linken binauralen Kanal und der parametrisierten perzeptuellen Übertragungsfunktion für den rechten binauralen Kanal von dem linken Frontkanal ist;

$\varphi(rf)$ die mittlere Phasendifferenz je Frequenzband zwischen der parametrisierten perzeptuellen Übertragungsfunktion für den linken binauralen Kanal und der parametrisierten perzeptuellen Übertragungsfunktion für den rechten binauralen Kanal von dem rechten Frontkanal ist;

$\varphi(lr)$ die mittlere Phasendifferenz je Frequenzband zwischen der parametrisierten perzeptuellen Übertragungsfunktion für den linken binauralen Kanal und der parametrisierten perzeptuellen Übertragungsfunktion für den rechten binauralen Kanal von dem linken Rückkanal ist;

$\varphi(rr)$ die mittlere Phasendifferenz je Frequenzband zwischen der parametrisierten perzeptuellen Übertragungsfunktion für den linken binauralen Kanal und der parametrisierten perzeptuellen Übertragungsfunktion für de rechten binauralen Kanal von dem rechten Rückkanal ist;

und $m_{11}$, $m_{21}$, $m_{31}$, $m_{12}$, $m_{22}$, $m_{32}$, $m_{13}$, $m_{23}$, und $m_{33}$ von den räumlichen Parametern abhängig sind, und zwar auf dieselbe Art und Weise wie in einer zwei-zu-drei-Aufwärtsmischeinheit eines 5.1 MPEG Surround-Decoders.

3. Räumliche Decoderanordnung (2) zum Schaffen eines Paares binauraler Ausgangskanäle (lb, rb) aus einem Eingangsbitstrom (Beleuchtungssystem), wobei die Anordnung Folgendes umfasst:

- eine Demultiplexereinheit (21) zum Demultiplexen des Eingangsbitstroms in wenigstens einen Heruntermischkanal und räumliche Parameter (sp),
- eine Heruntermisch-Decodereinheit (22) zum Decodieren des wenigstens einen Heruntermischkanals (s), und
- eine räumliche Decodereinheit (23) nach Anspruch 1 oder 2.

4. Die räumliche Decoderanordnung nach Anspruch 2, wobei die räumliche Decodereinheit (23) eine Nachhalleinheit (237) aufweist.

5. Audiosystem mit einer räumlichen Decodereinheit (23) nach Anspruch 1 oder 2, und/oder mit einer räumlichen Decoderanordnung (2) nach Anspruch 3.

6.  Heimgerät mit einer räumlichen Decodereinheit (23) nach Anspruch 1 oder 2 und/oder mit einer räumlichen Decoderanordnung (2) nach Anspruch 3.

7.  Verfahren zum Schaffen eines Paares binauraler Ausgangskanäle (lb, rb) unter Verwendung räumlicher Parameter (sp) und eines Heruntermischeingangskanals (s), wobei das Verfahren **dadurch gekennzeichnet ist, dass** es die nachfolgenden Verfahrensschritte umfasst:

> - das Umwandeln der räumlichen Parameter (sp) in binaurale Parameter (bp), unter Verwendung parametrisierter perzeptueller Übertragungsfunktionen (hp), wobei die binauralen Parameter von den räumlichen Parametern (sp) sowie von den parametrisierten perzeptuellen Übertragungsfunktionen abhängig sind;
> - das Transformieren des Audio-Heruntermischeingangskanals in einen transformierten Audio-Eingangskanal in der QMF-Domäne,
> - das Erzeugen einer dekorrelierten Version des transformierten Audio-Eingangskanals;
> - das Synthetisieren eines Paares transformierter binauraler Kanäle (Lb, Rb) als:

$$\begin{bmatrix} Lb[k,m] \\ Rb[k,m] \end{bmatrix} = H_k \begin{bmatrix} L[k,m] \\ R[k,m] \end{bmatrix} = \begin{bmatrix} h_{11} & h_{12} \\ h_{21} & h_{22} \end{bmatrix}_k \begin{bmatrix} S[k,m] \\ D[k,m] \end{bmatrix}$$

> wobei der Index k einen QMF Hybridfrequenzbandindex bezeichnet und Index m einen QMF Schlitzzeitindex bezeichnet, wobei die Parameter $h_{ij}$ der Matrix $H_k$ durch die binauralen Parameter bestimmt werden und S[k,m] der transformierte Audio-Eingangskanal und D[k,m] die dekorrelierte Version des transformierten Audio-Eingangskanals ist;
> - das invertierte Transformieren der transformierten binauralen Kanäle (Lb, Rb) in das Paar binauraler Ausgangskanäle (lb, rb); und wobei die Matrixkoeffizienten gegeben werden durch:

$$h_{11} = g_B c_L \cos(\alpha + \beta) \exp(j\mathrm{IPD}_B / 2)$$

$$h_{12} = g_B c_L \sin(\alpha + \beta) \exp(j\mathrm{IPD}_B / 2)$$

$$h_{21} = g_B c_R \cos(-\alpha + \beta) \exp(-j\mathrm{IPD}_B / 2)$$

$$h_{22} = g_B c_R \sin(-\alpha + \beta) \exp(-j\mathrm{IPD}_B / 2)$$

> wobei

$$g_B = \sqrt{\sigma_L^2 + \sigma_R^2}$$

$$\alpha = 0.5 \arccos(\mathrm{ICC}_B)$$

$$\beta = \arctan\left( \frac{c_R - c_L}{c_R + c_L} \tan(\alpha) \right)$$

$$c_L = \sqrt{\frac{10^{\mathrm{CLD}_B / 10}}{1 + 10^{\mathrm{CLD}_B / 10}}}$$

$$c_R = \sqrt{\frac{1}{1+10^{\mathrm{CLD}_B/10}}}$$

mit

$$\mathrm{IPD}_B = \arg\left(\left\langle L_B R_B^* \right\rangle\right)$$

$$\mathrm{ICC}_B = \frac{\left|\left\langle L_B R_B^* \right\rangle\right|}{\sigma_L \sigma_R}$$

$$\mathrm{CLD}_B = 10\log_{10}\left(\frac{\sigma_{\mathrm{L}}^2}{\sigma_{\mathrm{R}}^2}\right)$$

wobei arg eine Argumentfunktion bezeichnet, | | eine Absolutwertfunktion bezeichnet und * ein komplexes Konjugieren bezeichnet, und

- das Berechnen der relativen Potenzen $\sigma_{lf}^2, \sigma_{rf}^2, \sigma_c^2, \sigma_{ls}^2$, und, $\sigma_{rs}^2$ der fünf Kanäle gegenüber einem Audio-Heruntermischeingangskanal von den räumlichen Parametern wie

$$\sigma_{lf}^2 = r_1(\mathrm{CLD}_{fs})r_1(\mathrm{CLD}_{fc})r_1(\mathrm{CLD}_f),$$

$$\sigma_{rf}^2 = r_1(\mathrm{CLD}_{fs})r_1(\mathrm{CLD}_{fc})r_2(\mathrm{CLD}_f),$$

$$\sigma_c^2 = r_1(\mathrm{CLD}_{fs})r_2(\mathrm{CLD}_{fc}),$$

$$\sigma_{ls}^2 = r_2(\mathrm{CLD}_{fs})r_1(\mathrm{CLD}_s),$$

$$\sigma_{rs}^2 = r_2(\mathrm{CLD}_{fs})r_2(\mathrm{CLD}_s),$$

mit

$$r_1(\mathrm{CLD}) = \frac{10^{\mathrm{CLD}/10}}{1+10^{\mathrm{CLD}/10}},$$

und

$$r_2(\mathrm{CLD}) = \frac{1}{1+10^{\mathrm{CLD}/10}},$$

und wobei

CLD$_{fs}$ ein Parameter der räumlichen Parameter ist, der eine Pegeldifferenz für Frontkanäle und Rückkanäle definiert;

CLD$_{fe}$ ein Parameter der räumlichen Parameter ist, der eine Pegeldifferenz für Frontkanäle gegen einen Zentralkanal definiert;

CLD$_f$ ein Parameter der räumlichen Parameter ist, der eine Pegeldifferenz für den linken Frontkanal gegen den rechten Frontkanal definiert; und

CLD$_s$ ein Parameter der räumlichen Parameter ist, der eine Pegeldifferenz für den linken Rückkanal gegen den rechten Rückkanal definiert; und

das Berechnen, auf Basis der relativen Potenzen $\sigma_{lf}^2, \sigma_{rf}^2, \sigma_c^2, \sigma_{ls}^2,$ und, $\sigma_{rs}^2$, des erwarteten Wertes der relativen Potenz $\sigma_L^2$ des linken binauralen Ausgangskanals, und des erwarteten Wertes der relativen Potenz $\sigma_R^2$ des rechten binauralen Ausgangskanals und des erwarteten Wertes des Kreuzproduktes L$_B$R$_B$.

8. Verfahren zum Schaffen eines Paares binauraler Ausgangskanäle (lb, rb) unter Verwendung räumlicher Parameter (sp) und zweiter Audio-Eingangskanäle (l, r), wobei das Verfahren **dadurch gekennzeichnet ist, dass** es die nachfolgenden Verfahrensschritte umfasst:

- das Umwandeln der räumlichen Parameter (sp) in binaurale Parameter (bp) unter Verwendung parametrisierter perzeptueller Übertragungsfunktionen (hp), wobei die binauralen Parameter von den räumlichen Parametern (sp) sowie von den parametrisierten perzeptuellen Übertragungsfunktionen abhängig sind;
- das Transformieren der zwei Audio-Eingangskanäle in transformierte Audio-Eingangskanäle in der QMF-Domäne,
- das Synthetisieren eines Paares transformierter binauraler Kanäle (Lb, Rb) als:

$$\begin{bmatrix} Lb[k,m] \\ Rb[k,m] \end{bmatrix} = H_k \begin{bmatrix} L[k,m] \\ R[k,m] \end{bmatrix} = \begin{bmatrix} h_{11} & h_{12} \\ h_{21} & h_{22} \end{bmatrix}_k \begin{bmatrix} S[k,m] \\ D[k,m] \end{bmatrix}$$

wobei der Index k einen QMF Hybridfrequenzbandindex bezeichnet und Index m einen QMF Schlitzzeitindex bezeichnet, wobei die Parameter h$_{ij}$ der Matrix H$_k$ durch die binauralen Parameter bestimmt werden und L[k,m] und R[k,m] QMF transformierte Audio-Eingangssignale sind; und

- das invertierte Transformieren der synthetisierten binauralen Kanäle in das Paar binauraler Ausgangskanäle; wobei die Matrixkoeffizienten gegeben werden durch:

$$h_{11} = m_{11}H_l(l) + m_{21}H_l(r) + m_{31}H_l(c)$$

$$h_{12} = m_{12}H_l(l) + m_{22}H_l(r) + m_{32}H_l(c)$$

$$h_{21} = m_{11}H_r(l) + m_{21}H_r(r) + m_{31}H_r(c)$$

$$h_{22} = m_{12}H_r(l) + m_{22}H_r(r) + m_{32}H_r(c)$$

wobei

$$H_l(c) = P_l(c)e^{-j\phi(c)/2}$$

$$H_r(c) = Pr(c)e^{-j\phi(c)/2}$$

$$H_l(l) = \sqrt{w_{lf}^2 P_l^2(lf) + w_{lr}^2 P_l^2(lr)}$$

$$H_r(l) = e^{-j(w_{lf}^2 \phi(lf) + w_{ls}^2 \phi(lr))} \sqrt{w_{lf}^2 P_r^2(lf) + w_{lr}^2 P_r^2(lr)}$$

$$H_l(r) = e^{+j(w_{rf}^2 \phi(rf) + w_{rs}^2 \phi(rr))} \sqrt{w_{rf}^2 P_l^2(rf) + w_{rr}^2 P_l^2(rs)} \; ;$$

$$H_r(r) = \sqrt{w_{rf}^2 P_r^2(rf) + w_{rr}^2 P_r^2(rr)}$$

mit

$$w_{lf}^2 = \frac{10^{CLD_l/10}}{1 + 10^{CLD_l/10}}$$

$$w_{lr}^2 = \frac{1}{1 + 10^{CLD_l/10}}$$

$$w_{rf}^2 = \frac{10^{CLD_r/10}}{1 + 10^{CLD_r/10}}$$

$$w_{rr}^2 = \frac{1}{1 + 10^{CLD_r/10}}$$

wobei

$CLD_1$ ein Parameter der räumlichen Parameter ist, der eine Pegeldifferenz für einen linken Frontkanal gegen einen linken Rückkanal definiert;

$CLD_r$ ein Parameter der räumlichen Parameter ist, der eine Pegeldifferenz für einen rechten Frontkanal gegen einen rechten Rückkanal definiert;
und

$P_l(c)$ der mittlere Potenzpegel je Frequenzband einer parametrisierten perzeptuellen Übertragungsfunktion für einen linken binauralen Kanal von einem Zentralkanal ist;

$P_r(c)$ der mittlere Potenzpegel je Frequenzband der parametrisierten perzeptuellen Übertragungsfunktion für einen rechten binauralen Kanal von dem Zentralkanal ist;

$P_l(lf)$ der mittlere Pegel je Frequenzband einer parametrisierten perzeptuellen Übertragungsfunktion für den linken binauralen Kanal von dem linken Frontkanal ist;

$P_l(rf)$ der mittlere Pegel je Frequenzband einer parametrisierten perzeptuellen Übertragungsfunktion für den linken binauralen Kanal von dem rechten Frontkanal ist;

$P_l(lr)$ der mittlere Pegel je Frequenzband einer parametrisierten perzeptuellen Übertragungsfunktion für den linken binauralen Kanal von dem linken Rückkanal ist;

$P_l(rr)$ der mittlere Pegel je Frequenzband einer parametrisierten perzeptuellen Übertragungsfunktion für den linken binauralen Kanal von dem rechten Rückkanal ist;

$P_r(lf)$ der mittlere Pegel je Frequenzband einer parametrisierten perzeptuellen Übertragungsfunktion für den rechten binauralen Kanal von dem linken Frontkanal ist;

$P_r(rf)$ der mittlere Pegel je Frequenzband einer parametrisierten perzeptuellen Übertragungsfunktion für den rechten binauralen Kana von dem rechten Frontkanal ist;

$P_r$(lr) der mittlere Pegel je Frequenzband einer parametrisierten perzeptuellen Übertragungsfunktion für den rechten binauralen Kanal von dem linken Rückkanal ist;

$P_r$(rr) der mittlere Pegel je Frequenzband einer parametrisierten perzeptuellen Übertragungsfunktion für den rechten binauralen Kanal von dem rechten Rückkanal ist;

$\varphi$(c) die mittlere Phasendifferenz je Frequenzband zwischen der parametrisierten perzeptuellen Übertragungsfunktion für den linken binauralen Kanal und der parametrisierten perzeptuellen Übertragungsfunktion für den rechten binauralen Kanal von dem Zentralkanal ist;

$\varphi$(lf) die mittlere Phasendifferenz je Frequenzband zwischen der parametrisierten perzeptuellen Übertragungsfunktion für den linken binauralen Kanal und der parametrisierten perzeptuellen Übertragungsfunktion für den rechten binauralen Kanal von dem linken Frontkanal ist;

$\varphi$(rf) die mittlere Phasendifferenz je Frequenzband zwischen der parametrisierten perzeptuellen Übertragungsfunktion für den linken binauralen Kanal und der parametrisierten perzeptuellen Übertragungsfunktion für den rechten binauralen Kanal von dem rechten Frontkanal ist;

$\varphi$(lr) die mittlere Phasendifferenz je Frequenzband zwischen der parametrisierten perzeptuellen Übertragungsfunktion für den linken binauralen Kanal und der parametrisierten perzeptuellen Übertragungsfunktion für den rechten binauralen Kanal von dem linken Rückkanal ist;

$\varphi$(rr) die mittlere Phasendifferenz je Frequenzband zwischen der parametrisierten perzeptuellen Übertragungsfunktion für den linken binauralen Kanal und der parametrisierten perzeptuellen Übertragungsfunktion für de rechten binauralen Kanal von dem rechten Rückkanal ist;

und $m_{11}$, $m_{21}$, $m_{31}$, $m_{12}$, $m_{22}$, $m_{32}$, $m_{13}$, $m_{23}$, und $m_{33}$ von den räumlichen Parametern abhängig sind, und zwar auf dieselbe Art und Weise wie in einer zwei-zu-drei-Aufwärtsmischeinheit eines 5.1 MPEG Surround-Decoders.

9. Computerprogrammprodukt zum Durchführen des Verfahrens nach Anspruch 7 oder 8.

**Revendications**

1. Unité de décodeur spatial (23) qui est destinée à produire une paire de canaux de sortie binauraux (lb, rb) à l'aide de paramètres spatiaux (sp) et un canal d'entrée de mixage descendant audio (s), le dispositif étant **caractérisé en ce qu'**il comprend :

   - une unité de conversion de paramètre (234) qui est destinée à convertir les paramètres spatiaux (sp) en des paramètres binauraux (bp) à l'aide de fonctions de transfert perceptives paramétrées (hp), les paramètres binauraux étant dépendants des paramètres spatiaux (sp) aussi bien que des fonctions de transfert perceptives paramétrées ;
   - une unité de transformation qui est destinée à transformer le canal d'entrée de mixage descendant audio en un canal d'entrée audio transformé dans le domaine QMF ;
   - une unité de décorrélation (239) qui est destinée à générer une version décorrélée du canal d'entrée audio transformé ;
   - une unité de synthèse spatiale (232) qui est destinée à synthétiser une paire de canaux binauraux transformés (Lb, Rb) en tant que :

$$\begin{bmatrix} Lb[k,m] \\ Rb[k,m] \end{bmatrix} = \mathrm{H}_k \begin{bmatrix} L[k,m] \\ R[k,m] \end{bmatrix} = \begin{bmatrix} h_{11} \ldots h_{12} \\ h_{21} \ldots h_{22} \end{bmatrix}_k \begin{bmatrix} S[k,m] \\ D[k,m] \end{bmatrix}$$

   où l'indice k indique un indice de bande de fréquences hybride QMF et l'indice m indique un indice de tranche de temps QMF avec les paramètres $h_{ij}$ de la matrice $H_k$ étant déterminés par les paramètres binauraux, et où S[k,m] est le canal d'entrée audio transformé et D[k,m] est la version décorrélée du canal d'entrée audio transformé ;
   - une paire d'unités de transformation inverse pour la transformation inverse des canaux binauraux synthétisés en paire de canaux de sortie binauraux où les coefficients de la matrice sont donnés par :

$$h_{11} = g_B c_L \cos(\alpha + \beta) \exp(j\mathrm{IPD}_B / 2)$$

$$h_{12} = g_B c_L \sin(\alpha + \beta) \exp(j\mathrm{IPD}_B / 2)$$

$$h_{21} = g_B c_R \cos(-\alpha + \beta) \exp(-j\mathrm{IPD}_B / 2)$$

$$h_{22} = g_B c_R \sin(-\alpha + \beta) \exp(-j\mathrm{IPD}_B / 2)$$

où

$$g_B = \sqrt{\sigma_L^2 + \sigma_R^2}$$

$$\alpha = 0{,}5 \arccos(\mathrm{ICC}_B)$$

$$\beta = \arctan\left(\frac{c_R - c_L}{c_R + c_L} \tan(\alpha)\right)$$

$$c_L = \sqrt{\frac{10^{CLD_B/10}}{1 + 10^{CLD_B/10}}}$$

$$c_R = \sqrt{\frac{1}{1 + 10^{CLD_B/10}}}$$

avec

$$\mathrm{IPD}_B = \arg\left(\left\langle L_B R_B^* \right\rangle\right)$$

$$\mathrm{ICC}_B = \frac{\left|\left\langle L_B R_B^* \right\rangle\right|}{\sigma_L \sigma_R}$$

$$\mathrm{CLD}_B = 10 \log_{10}\left(\frac{\sigma_L^2}{\sigma_R^2}\right)$$

où arg indique une fonction d'argument, | | indique une fonction de valeur absolue et * indique un conjugué complexe, et

des moyens qui sont destinés à calculer les puissances relatives $\sigma_{lf}^2$, $\sigma_{rf}^2$,

$\sigma_c^2$, $\sigma_{ls}^2$ et $\sigma_{rs}^2$ des cinq canaux par rapport à l'un canal d'entrée de mixage descendant audio à partir des paramètres spatiaux en tant que :

$$\sigma_{lf}^2 = r_1(CLD_{fs})r_1(CLD_{fc})r_1(CLD_f),$$

$$\sigma_{rf}^2 = r_1(CLD_{fs})r_1(CLD_{fc})r_2(CLD_f),$$

$$\sigma_c^2 = r_1(CLD_{fs})r_2(CLD_{fc}),$$

$$\sigma_{ls}^2 = r_2(CLD_{fs})r_1(CLD_s),$$

$$\sigma_{rs}^2 = r_2(CLD_{fs})r_2(CLD_s),$$

avec

$$r_1(CLD) = \frac{10^{CLD/10}}{1+10^{CLD/10}},$$

et

$$r_2(CLD) = \frac{1}{1+10^{CLD/10}},$$

et où

CLD$_{fs}$ est un paramètre des paramètres spatiaux définissant une différence de niveau pour des canaux avant contre des canaux arrière ;
CLD$_{fc}$ est un paramètre des paramètres spatiaux définissant une différence de niveau pour des canaux avant contre un canal central ;
CLD$_f$ est un paramètre des paramètres spatiaux définissant une différence de niveau pour le canal avant gauche contre le canal avant droit ; et
CLD$_s$ est un paramètre des paramètres spatiaux définissant une différence de niveau pour le canal arrière gauche contre le canal arrière droit ; et

des moyens pour calculer, sur la base des puissances relatives $\sigma_{lf}^2$, $\sigma_{rf}^2$, $\sigma_c^2$, $\sigma_{ls}^2$ et $\sigma_{rs}^2$, la valeur attendue de la puissance relative $\sigma_L^2$ du canal de sortie binaural gauche,

et la valeur attendue de la puissance relative $\sigma_R^2$ du canal de sortie binaural droit et de la valeur attendue du produit vectoriel $L_B R_B$.

2. Unité de décodeur spatial (23) qui est destinée à produire une paire de canaux de sortie binauraux (lb, rb) à l'aide de paramètres spatiaux (sp) et deux canaux d'entrée audio (l, r), le dispositif étant **caractérisé en ce qu'**il comprend :

- une unité de conversion de paramètre (234) qui est destinée à convertir les paramètres spatiaux (sp) en des paramètres binauraux (bp) à l'aide de fonctions de transfert perceptives paramétrées (hp), les paramètres binauraux étant dépendants des paramètres spatiaux (sp) aussi bien que des fonctions de transfert perceptives paramétrées ;
- deux unités de transformation qui sont destinées à transformer les deux canaux d'entrée audio en des canaux d'entrée audio transformés dans le domaine QMF ;
- une unité de synthèse spatiale (232) qui est destinée à synthétiser une paire de canaux binauraux transformés (Lb, Lr) en tant que :

$$\begin{bmatrix} Lb[k,m] \\ Rb[k,m] \end{bmatrix} = H_k \begin{bmatrix} L[k,m] \\ R[k,m] \end{bmatrix} = \begin{bmatrix} h_{11}....h_{12} \\ h_{21}....h_{22} \end{bmatrix}_k \begin{bmatrix} S[k,m] \\ D[k,m] \end{bmatrix}$$

où l'indice k indique un indice de bande de fréquences hybride QMF et l'indice m indique un indice de tranche de temps QMF avec les paramètres $h_{ij}$ de la matrice $H_k$ étant déterminés par les paramètres binauraux, et où L[k,m] et R[k,m] sont des signaux d'entrée audio transformés ; et
- une paire d'unités de transformation inverse pour la transformation inverse des canaux binauraux synthétisés en paire de canaux de sortie binauraux où les coefficients de la matrice sont donnés par :

$$h_{11} = m_{11}H_l(l) + m_{21}H_l(r) + m_{31}H_l(c)$$

$$h_{12} = m_{12}H_l(l) + m_{22}H_l(r) + m_{32}H_l(c)$$

$$h_{21} = m_{11}H_r(l) + m_{21}H_r(r) + m_{31}H_r(c)$$

$$h_{22} = m_{12}H_r(l) + m_{22}H_r(r) + m_{32}H_r(c)$$

où

$$H_l(c) = P_l(c)e^{-j\phi(c)/2}$$

$$H_r(c) = Pr(c)e^{-j\phi(c)/2}$$

$$H_l(l) = \sqrt{w_{lf}^2 P_l^2(lf) + w_{lr}^2 P_l^2(lr)}$$

$$H_r(l) = e^{-j(w_{lf}^2\phi(lf)+w_{ls}^2\phi(lr))}\sqrt{w_{lf}^2 P_r^2(lf) + w_{lr}^2 P_r^2(lr)}$$

$$H_l(r) = e^{+j(w_{rf}^2\phi(rf)+w_{rs}^2\phi(rr))}\sqrt{w_{rf}^2 P_l^2(rf) + w_{rr}^2 P_l^2(rs)} \ ;$$

et

$$H_r(r) = \sqrt{w_{rf}^2 P_r^2(rf) + w_{rr}^2 P_r^2(rr)}$$

avec

$$w_{lf}^2 = \frac{10^{CLD_l/10}}{1+10^{CLD_l/10}}$$

$$w_{lr}^2 = \frac{1}{1 + 10^{CLD_l/10}}$$

$$w_{rf}^2 = \frac{10^{CLD_r/10}}{1 + 10^{CLD_r/10}}$$

$$w_{rr}^2 = \frac{1}{1 + 10^{CLD_r/10}}$$

où

$CLD_l$ est un paramètre des paramètres spatiaux définissant une différence de niveau pour un canal avant gauche contre un canal arrière gauche ;

$CLD_r$ est un paramètre des paramètres spatiaux définissant une différence de niveau pour un canal avant droit contre un canal arrière droit ;

et

$P_l(c)$ est le niveau de puissance moyen par bande de fréquences d'une fonction de transfert perceptive paramétrée pour un canal binaural gauche à partir d'un canal central ;

$P_r(c)$ est le niveau de puissance moyen par bande de fréquences de la fonction de transfert perceptive paramétrée pour un canal binaural droit à partir du canal central ;

$P_l(lf)$ est le niveau moyen par bande de fréquences d'une fonction de transfert perceptive paramétrée pour le canal binaural gauche à partir du canal avant gauche ;

$P_l(rf)$ est le niveau moyen par bande de fréquences d'une fonction de transfert perceptive paramétrée pour le canal binaural gauche à partir du canal avant droit ;

$P_l(lr)$ est le niveau moyen par bande de fréquences d'une fonction de transfert perceptive paramétrée pour le canal binaural gauche à partir du canal arrière gauche ;

$P_l(rr)$ est le niveau moyen par bande de fréquences d'une fonction de transfert perceptive paramétrée pour le canal binaural gauche à partir du canal arrière droit ;

$P_r(lf)$ est le niveau moyen par bande de fréquences d'une fonction de transfert perceptive paramétrée pour le canal binaural droit à partir du canal avant gauche ;

$P_r(rf)$ est le niveau moyen par bande de fréquences d'une fonction de transfert perceptive paramétrée pour le canal binaural droit à partir du canal avant droit ;

$P_r(lr)$ est le niveau moyen par bande de fréquences d'une fonction de transfert perceptive paramétrée pour le canal binaural droit à partir du canal arrière gauche ;

$P_r(rr)$ est le niveau moyen par bande de fréquences d'une fonction de transfert perceptive paramétrée pour le canal binaural droit à partir du canal arrière droit ;

$\varphi_{(c)}$ est la différence de phase moyenne par bande de fréquences entre la fonction de transfert perceptive paramétrée pour le canal binaural gauche et la fonction de transfert perceptive paramétrée pour le canal binaural droit à partir du canal central ;

$\varphi_{(lf)}$ est la différence de phase moyenne par bande de fréquences entre la fonction de transfert perceptive paramétrée pour le canal binaural gauche et la fonction de transfert perceptive paramétrée pour le canal binaural droit à partir du canal avant gauche ;

$\varphi_{(rf)}$ est la différence de phase moyenne par bande de fréquences entre la fonction de transfert perceptive paramétrée pour le canal binaural gauche et la fonction de transfert perceptive paramétrée pour le canal binaural droit à partir du canal avant droit ;

$\varphi_{(lr)}$ est la différence de phase moyenne par bande de fréquences entre la fonction de transfert perceptive paramétrée pour le canal binaural gauche et la fonction de transfert perceptive paramétrée pour le canal binaural droit à partir du canal arrière gauche ;

$\varphi_{(rr)}$ est la différence de phase moyenne par bande de fréquences entre la fonction de transfert perceptive paramétrée pour le canal binaural gauche et la fonction de transfert perceptive paramétrée pour le canal binaural droit à partir du canal arrière droit ; et

$m_{11}$, $m_{21}$, $m_{31}$, $m_{12}$, $m_{22}$, $m_{32}$, $m_{13}$, $m_{23}$ et $m_{33}$ sont fonction des paramètres spatiaux de la même manière que dans une unité de mixage ascendant de deux à trois d'un décodeur dit surround MPEG 5.1.

**3.** Dispositif de décodeur spatial (2) qui est destiné à produire une paire de canaux de sortie binauraux (lb, rb) à partir d'un train de bits d'entrée (bs), le dispositif comprenant :

- une unité de démultiplexeur (21) qui est destinée à démultiplexer le train de bits d'entrée dans au moins un canal de mixage descendant et les paramètres spatiaux (sp) ;
- une unité de décodeur de mixage descendant (22) qui est destinée à décoder l'au moins un canal de mixage descendant (s) ; et
- une unité de décodeur spatial (23) selon la revendication 1 ou selon la revendication 2.

**4.** Dispositif de décodeur spatial selon la revendication 2, dans lequel l'unité de décodeur spatial (23) comprend une unité de réverbération (237).

**5.** Système audio comprenant une unité de décodeur spatial (23) selon la revendication 1 ou selon la revendication 2 et/ou un dispositif de décodeur spatial (2) selon la revendication 3.

**6.** Dispositif de consommateur comprenant une unité de décodeur spatial (23) selon la revendication 1 ou selon la revendication 2 et/ou un dispositif de décodeur spatial (2) selon la revendication 3.

**7.** Procédé qui est destiné à produire une paire de canaux de sortie binauraux (lb, rb) à l'aide de paramètres spatiaux (sp) et canal d'entrée de mixage descendant (s), le procédé étant **caractérisé en ce qu'**il comprend les étapes suivantes consistant à :

- convertir les paramètres spatiaux (sp) en paramètres binauraux (bp) à l'aide de fonctions de transfert perceptives paramétrées (hp), les paramètres binauraux étant dépendants des paramètres spatiaux (sp) aussi bien que des fonctions de transfert perceptives paramétrées ;
- transformer le canal d'entrée de mixage descendant audio en un canal d'entrée audio transformé dans le domaine QMF ;
- générer une version décorrélée du canal d'entrée audio transformé ;
- synthétiser une paire de canaux binauraux transformés (Lb, Rb) en tant que :

$$\begin{bmatrix} Lb[k,m] \\ Rb[k,m] \end{bmatrix} = \mathrm{H_k} \begin{bmatrix} L[k,m] \\ R[k,m] \end{bmatrix} = \begin{bmatrix} h_{11}...h_{12} \\ h_{21}...h_{22} \end{bmatrix}_k \begin{bmatrix} S[k,m] \\ D[k,m] \end{bmatrix}$$

où l'indice k indique un indice de bande de fréquences hybride QMF et l'indice m indique un indice de tranche de temps QMF avec les paramètres $h_{ij}$ de la matrice $H_k$ étant déterminés par les paramètres binauraux, et où S[k,m] est le canal d'entrée audio transformé et D[k,m] est la version décorrélée du canal d'entrée audio transformé ;
- transformer inversement les canaux binauraux transformés (Lb, Rb) en paire de canaux de sortie binauraux (lb, rb) et dans lequel les coefficients de la matrice sont donnés par :

$$h_{11} = g_B c_L \cos(\alpha + \beta) \exp(j\mathrm{IPD_B} / 2)$$

$$h_{12} = g_B c_L \sin(\alpha + \beta) \exp(j\mathrm{IPD_B} / 2)$$

$$h_{21} = g_B c_R \cos(-\alpha + \beta) \exp(-j\mathrm{IPD_B} / 2)$$

$$h_{22} = g_B c_R \sin(-\alpha + \beta) \exp(-j\mathrm{IPD_B} / 2)$$

où

$$g_B = \sqrt{\sigma_L^2 + \sigma_R^2}$$

$$\alpha = 0{,}5 \ \mathrm{arccos}(\mathrm{ICC_B})$$

$$\beta = \arctan\left(\frac{c_R - c_L}{c_R + c_L}\tan(\alpha)\right)$$

$$c_L = \sqrt{\frac{10^{CLD_B/10}}{1 + 10^{CLD_B/10}}}$$

$$c_R = \sqrt{\frac{1}{1 + 10^{CLD_B/10}}}$$

avec

$$\mathrm{IPD_B} = \arg\left(\left\langle L_B R_B^* \right\rangle\right)$$

$$\mathrm{ICC_B} = \frac{\left|\left\langle L_B R_B^* \right\rangle\right|}{\sigma_L \sigma_R}$$

$$\mathrm{CLD_B} = 10 \ \log_{10}\left(\frac{\sigma_L^2}{\sigma_R^2}\right)$$

où arg indique une fonction d'argument, | | indique une fonction de valeur absolue et * indique un conjugué complexe, et

calculer les puissances relatives $\sigma_{lf}^2$, $\sigma_{rf}^2$, $\sigma_c^2$, $\sigma_{ls}^2$ et $\sigma_{rs}^2$ des cinq canaux par rapport à l'un canal d'entrée de mixage descendant audio à partir des paramètres spatiaux en tant que :

$$\sigma_{lf}^2 \ = \ r_1(\mathrm{CLD_{fs}})r_1(\mathrm{CLD_{fc}})r_1(\mathrm{CLD_f}),$$

$$\sigma_{rf}^2 \ = \ r_1(\mathrm{CLD_{fs}})r_1(\mathrm{CLD_{fc}})r_2(\mathrm{CLD_f}),$$

$$\sigma_c^2 \ = \ r_1(\mathrm{CLD_{fs}})r_2(\mathrm{CLD_{fc}}),$$

$$\sigma_{ls}^2 \ = \ r_2(\mathrm{CLD_{fs}})r_1(\mathrm{CLD_s}),$$

$$\sigma_{rs}^2 = r_2(\text{CLD}_{fs})r_2(\text{CLD}_s),$$

avec

$$r_1(\text{CLD}) = \frac{10^{CLD/10}}{1+10^{CLD/10}},$$

et

$$r_2(\text{CLD}) = \frac{1}{1+10^{CLD/10}},$$

et où

$\text{CLD}_{fs}$ est un paramètre des paramètres spatiaux définissant une différence de niveau pour des canaux avant contre des canaux arrière ;

$\text{CLD}_{fc}$ est un paramètre des paramètres spatiaux définissant une différence de niveau pour des canaux avant contre un canal central ;

$\text{CLD}_f$ est un paramètre des paramètres spatiaux définissant une différence de niveau pour le canal avant gauche contre le canal avant droit ; et

$\text{CLD}_s$ est un paramètre des paramètres spatiaux définissant une différence de niveau pour le canal arrière gauche contre le canal arrière droit ; et

calculer, sur la base des puissances relatives $\sigma_{lf}^2$, $\sigma_{rf}^2$, $\sigma_c^2$, $\sigma_{ls}^2$ et $\sigma_{rs}^2$, la valeur attendue de la puissance relative $\sigma_L^2$ du canal de sortie binaural gauche, et la valeur attendue de la puissance relative $\sigma_R^2$ du canal de sortie binaural droit et de la valeur attendue du produit vectoriel $L_B R_B$.

8. Procédé qui est destiné à produire une paire de canaux de sortie binauraux (lb, rb) à l'aide de paramètres spatiaux (sp) et deux canaux d'entrée audio (l, r), le procédé étant **caractérisé en ce qu'**il comprend les étapes suivantes consistant à :

- convertir les paramètres spatiaux (sp) en des paramètres binauraux (bp) à l'aide de fonctions de transfert perceptives paramétrées (hp), les paramètres binauraux étant dépendants des paramètres spatiaux (sp) aussi bien que des fonctions de transfert perceptives paramétrées ;
- transformer les deux canaux d'entrée audio en des canaux d'entrée audio transformés dans le domaine QMF ;
- synthétiser une paire de canaux binauraux transformés (Lb, Rb) en tant que :

$$\begin{bmatrix} Lb[k,m] \\ Rb[k,m] \end{bmatrix} = \text{H}_k \begin{bmatrix} L[k,m] \\ R[k,m] \end{bmatrix} = \begin{bmatrix} h_{11} \dots h_{12} \\ h_{21} \dots h_{22} \end{bmatrix}_k \begin{bmatrix} L[k,m] \\ R[k,m] \end{bmatrix}$$

où l'indice k indique un indice de bande de fréquences hybride QMF et l'indice m indique un indice de tranche de temps QMF avec les paramètres $h_{ij}$ de la matrice $\text{H}_k$ étant déterminés par les paramètres binauraux, et où L[k,m] et R[k,m] sont des signaux d'entrée audio transformés ; et
- transformer inversement les canaux binauraux synthétisés en paire de canaux de sortie binauraux où les coefficients de la matrice sont donnés par :

$$h_{11} = m_{11} H_l(l) + m_{21} H_l(r) + m_{31} H_l(c)$$

$$h_{12} = m_{12}H_l(l) + m_{22}H_l(r) + m_{32}H_l(c)$$

$$h_{21} = m_{11}H_r(l) + m_{21}H_r(r) + m_{31}H_r(c)$$

$$h_{22} = m_{12}H_r(l) + m_{22}H_r(r) + m_{32}H_r(c)$$

où

$$H_l(c) = P_l(c)e^{-j\phi(c)/2}$$

$$H_r(c) = Pr(c)e^{-j\phi(c)/2}$$

$$H_l(l) = \sqrt{w_{lf}^2 P_l^2 (lf) + w_{lr}^2 P_l^2} (lr)$$

$$H_r(l) = e^{-j(w_{lf}^2\phi(lf)+w_{ls}^2\phi(lr))} \sqrt{w_{lf}^2 P_r^2 (lf) + w_{lr}^2 P_r^2} (lr)$$

$$H_l(r) = e^{+j(w_{rf}^2\phi(rf)+w_{rs}^2\phi(rr))} \sqrt{w_{rf}^2 P_l^2 (rf) + w_{rr}^2 P_l^2} (rs) \ ;$$

et

$$H_r(r) = \sqrt{w_{rf}^2 P_r^2 (rf) + w_{rr}^2 P_r^2} (rr)$$

avec

$$w_{lf}^2 = \frac{10^{CLD_l/10}}{1+10^{CLD_l/10}}$$

$$w_{lr}^2 = \frac{1}{1+10^{CLD_l/10}}$$

$$w_{rf}^2 = \frac{10^{CLD_r/10}}{1+10^{CLD_r/10}}$$

$$w_{rr}^2 = \frac{1}{1+10^{CLD_r/10}}$$

où

$CLD_l$ est un paramètre des paramètres spatiaux définissant une différence de niveau pour un canal avant gauche contre un canal arrière gauche ;

$CLD_r$ est un paramètre des paramètres spatiaux définissant une différence de niveau pour un canal avant droit contre un canal arrière droit ;

et

$P_l(c)$ est le niveau de puissance moyen par bande de fréquences d'une fonction de transfert perceptive paramétrée pour un canal binaural gauche à partir d'un canal central ;

$P_r(c)$ est le niveau de puissance moyen par bande de fréquences de la fonction de transfert perceptive paramétrée pour un canal binaural droit à partir du canal central ;

$P_l(lf)$ est le niveau moyen par bande de fréquences d'une fonction de transfert perceptive paramétrée pour le canal binaural gauche à partir du canal avant gauche ;

$P_l(rf)$ est le niveau moyen par bande de fréquences d'une fonction de transfert perceptive paramétrée pour le canal binaural gauche à partir du canal avant droit ;

$P_l(lr)$ est le niveau moyen par bande de fréquences d'une fonction de transfert perceptive paramétrée pour le canal binaural gauche à partir du canal arrière gauche ;

$P_l(rr)$ est le niveau moyen par bande de fréquences d'une fonction de transfert perceptive paramétrée pour le canal binaural gauche à partir du canal arrière droit ;

$P_r(lf)$ est le niveau moyen par bande de fréquences d'une fonction de transfert perceptive paramétrée pour le canal binaural droit à partir du canal avant gauche ;

$P_r(rf)$ est le niveau moyen par bande de fréquences d'une fonction de transfert perceptive paramétrée pour le canal binaural droit à partir du canal avant droit ;

$P_r(lr)$ est le niveau moyen par bande de fréquences d'une fonction de transfert perceptive paramétrée pour le canal binaural droit à partir du canal arrière gauche ;

$P_r(rr)$ est le niveau moyen par bande de fréquences d'une fonction de transfert perceptive paramétrée pour le canal binaural droit à partir du canal arrière droit ;

$\varphi_{(c)}$ est la différence de phase moyenne par bande de fréquences entre la fonction de transfert perceptive paramétrée pour le canal binaural gauche et la fonction de transfert perceptive paramétrée pour le canal binaural droit à partir du canal central ;

$\varphi_{(lf)}$ est la différence de phase moyenne par bande de fréquences entre la fonction de transfert perceptive paramétrée pour le canal binaural gauche et la fonction de transfert perceptive paramétrée pour le canal binaural droit à partir du canal avant gauche ;

$\varphi_{(rf)}$ est la différence de phase moyenne par bande de fréquences entre la fonction de transfert perceptive paramétrée pour le canal binaural gauche et la fonction de transfert perceptive paramétrée pour le canal binaural droit à partir du canal avant droit ;

$\varphi_{(lr)}$ est la différence de phase moyenne par bande de fréquences entre la fonction de transfert perceptive paramétrée pour le canal binaural gauche et la fonction de transfert perceptive paramétrée pour le canal binaural droit à partir du canal arrière gauche ;

$\varphi_{(rr)}$ est la différence de phase moyenne par bande de fréquences entre la fonction de transfert perceptive paramétrée pour le canal binaural gauche et la fonction de transfert perceptive paramétrée pour le canal binaural droit à partir du canal arrière droit ; et

$m_{11}, m_{21}, m_{31}, m_{12}, m_{22}, m_{32}, m_{13}, m_{23}$ et $m_{33}$ sont fonction des paramètres spatiaux de la même manière que dans une unité de mixage ascendant de deux à trois d'un décodeur dit surround MPEG 5.1.

9. Produit de programme informatique pour la mise en oeuvre du procédé selon la revendication 7 ou selon la revendication 8.

**FIG. 1** Prior Art

**FIG. 2** Prior Art

FIG. 3  Prior Art

FIG. 4  Prior Art

FIG. 5

FIG. 6

EP 1 927 266 B1

FIG. 7

FIG. 8

FIG. 9

## REFERENCES CITED IN THE DESCRIPTION

### Patent documents cited in the description

- WO 2004028204 A
- US 2003035553 A
- EP 1194007 A
- US 6111958 A

### Non-patent literature cited in the description

- **HERRE et al.** The Reference Model Architecture for MPEG Spatial Audio Coding. *Audio Engineering Society Convention Paper,* 28 May 2005
- **ENDEGARD et al.** Synthetic Ambiance in Parametric Stereo Coding. *Preprints of papers presented at the AES Convention,* 08 May 2004, 1-12
- **HERRE et al.** MP3 Surround: Efficient and Compatible Coding of Multi-Channel Audio. *Audio Engineering Society, Convention Preprint,* 08 May 2004
- **BAUMGARTE.** Binaural cue coding - Part 1: Psychoacoustic fundamentals and design principles. *IEEE transactions on Speech and Audio Processing,* vol. 11 (6), ISSN 1063-6676, 2003-11
- Binaural cue coding - Part II: Schemes and Applications. *IEEE transactions on Speech and Audio Processing,* vol. 11 (6), ISBN 1063-6676, 2003-11